(19) Europäisches Patentamt
European Patent Office
Office européen des brevets

(11) **EP 4 564 618 A2**

(12) **EUROPEAN PATENT APPLICATION**

(43) Date of publication:
**04.06.2025 Bulletin 2025/23**

(21) Application number: **24205459.1**

(22) Date of filing: **09.10.2024**

(51) International Patent Classification (IPC):
**H01S 5/10** $^{(2021.01)}$ **H01S 5/40** $^{(2006.01)}$
**H01S 5/12** $^{(2021.01)}$

(52) Cooperative Patent Classification (CPC):
**H01S 5/1237; H01S 5/1032; H01S 5/1064;
H01S 5/1206; H01S 5/4087;** H01S 5/1014

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.11.2023 US 202318522534**

(71) Applicant: **INTEL Corporation
Santa Clara, CA 95054 (US)**

(72) Inventors:
• **Kumar, Ranjeet
Milpitas, CA 95035 (US)**

• **Nguyen, Kimchau
Los Gatos, CA 95030 (US)**
• **Huang, Duanni
San Jose, CA 95134 (US)**
• **Rong, Haisheng
Pleasanton, CA 94566 (US)**
• **Jones, Richard
San Mateo, CA 95054 (US)**

(74) Representative: **Samson & Partner Patentanwälte
mbB
Widenmayerstraße 6
80538 München (DE)**

(54) **INTEGRATED DENSE WAVELENGTH DIVISION MULTIPLEXED LASER ARRAY**

(57) Integrated laser arrays, photonic devices, packages, and systems are disclosed. An example integrated laser array includes first and second lasers, each laser including a light-emitter structure and a waveguide with a grating. In one aspect, effective pitches of the gratings of the first and second lasers are different by less than about 5 angstroms, while the gratings of the first and second lasers are fabricated with a resolution of at least 1 nanometer. In another aspect, each laser includes a waveguide with left and right sidewall gratings, effective widths of the waveguides of the first and second lasers are different, and an offset between the left and right sidewall gratings of the second laser is different from an offset between the left and right sidewall gratings of the first laser. Integrated laser arrays described herein may be particularly suitable for being implemented in dense wavelength division multiplexed systems.

FIG. 4A

EP 4 564 618 A2

# Description

## Background

Many emerging applications such as optical interconnects (e.g., fiberoptic communications), optical computing, or light detection and ranging (LIDAR) use lasers to generate electromagnetic signals with wavelengths in the optical and microwave portions of electromagnetic spectrum (such signals referred to in the following, simply, as "light" or "optical signals"). A variety of factors can affect the cost, quality, and robustness of photonic devices that integrate light-emitting components and components used for guiding and/or manipulating light. Such photonic devices may be referred to as "integrated photonic devices." Physical constraints, such as space/surface area, and also power consumption can impose further constraints on integrated photonic devices.

## Brief Description of the Drawings

Embodiments will be readily understood by the following detailed description in conjunction with the accompanying drawings.

FIG. 1 is a schematic illustration of an example photonic device with an integrated laser array, according to an embodiment.

FIGS. 2A-2B are top-down views of two example lasers with surface gratings, according to various embodiments.

FIGS. 3A-3B are top-down views of two example lasers with sidewall gratings, according to various embodiments.

FIGS. 4A-4B are top-down views of two example lasers with surface and sidewall gratings, according to various embodiments.

FIG. 5 illustrates top-down views of waveguides with surface gratings of different effective pitches that may be used in different lasers of an integrated laser array, according to an embodiment.

FIG. 6 illustrates cross-sectional side views of the waveguides of FIG. 5 with perturbations of the gratings being implemented as trenches, according to an embodiment.

FIG. 7 illustrates cross-sectional side views of the waveguides of FIG. 5 with perturbations of the gratings being implemented as ridges, according to an embodiment.

FIG. 8 illustrates top-down views of waveguides with sidewall gratings and different effective widths that may be used in different lasers of an integrated laser array, and with perturbations of the gratings being implemented as trenches, according to an embodiment.

FIG. 9 illustrates top-down views of waveguides with sidewall gratings and different effective widths that may be used in different lasers of an integrated laser array, with perturbations of the gratings being implemented as ridges, according to an embodiment.

FIGS. 10A and 10B illustrate cross-sectional side views of one of the waveguides of FIGS. 8 and 9 in cross-sections of sidewall gratings on two different sidewalls, according to an embodiment.

FIG. 11 is a top view of a wafer and dies that may be included in a photonic device with an integrated laser array, according to an embodiment.

FIG. 12 is a side, cross-sectional view of an example microelectronic package that may include a photonic device with an integrated laser array, according to an embodiment.

FIG. 13 is a block diagram of an example photonic device that may include an integrated laser array, according to an embodiment.

## Detailed Description

Integrated laser arrays, photonic devices, packages, and systems are disclosed. An example integrated laser array includes first and second lasers, each laser including a light-emitter structure and a waveguide with a grating. In one aspect, effective pitches of the gratings of the first and second lasers are different by less than about 5 angstroms, while the gratings of the first and second lasers are fabricated with a resolution of at least 1 nanometer. In another aspect, each laser includes a waveguide with left and right sidewall gratings, effective widths of the waveguides of the first and second lasers are different, and an offset between the left and right sidewall gratings of the second laser is different from an offset between the left and right sidewall gratings of the first laser. Integrated laser arrays described herein may be particularly suitable for being implemented in dense wavelength division multiplexed (DWDM) systems, but may also be used in other systems where laser arrays are needed.

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating integrated laser arrays described herein, it might be useful to first understand phenomena that may come into play in some systems where integrated laser arrays may be used. The following foundational information may be viewed as a basis from which the present disclosure may be properly explained. Such information is offered for purposes of explanation only and, accordingly, should not be construed in any way to limit the broad scope of the present disclosure and its potential applications.

Typically lasers use direct bandgap semiconductor materials such as gallium arsenide (GaAs), indium phosphide (InP), gallium nitride (GaN), or other III-V semiconductors (i.e., semiconductors that are based on elements of group III and group V of the periodic system of elements) for light emission. Compared to indirect bandgap semiconductor materials such as silicon (Si), direct bandgap semiconductors are more fit for emitting light efficiently and coherently. However, semiconductor materials that may not be the most optimal for light generation may be preferable for light transmission and manipulation, with Si being the most prominent example of such a material. For example, Si may be used to fabricate waveguides, gratings, wavelength combiners, or other components of photonic integrated circuits (PICs).

Emerging Silicon Photonics (SiPh) based optical input/output (I/O) technology requires multi-wavelength laser sources to support high data rate for advanced optical communication and computing applications. These multi-wavelength lasers are a crucial part of an optical transmitter and are expected to enable improvements in performance, efficiency, cost, and bandwidth scaling. However, it is extremely challenging to meet the stringent wavelength spacing and power uniformity requirements for the lasers. One conventional approach to providing multi-wavelength lasers is to employ III-V laser arrays fabricated in III-V fabrication facilities. Another conventional approach includes using comb lasers such as Fabri-Perot and mode-locked based multi-wavelength comb lasers. Both of these approaches have limitations. For example, one limitation of the first approach is that III-V fabrication facilities are typically not equipped with advanced tools used in Si fabrication facilities, resulting in limited lithography available for fabricating different lasers of a laser array, leading to poor channel and power uniformity of a laser array. For the second approach, while the wavelength spacing of comb lasers may be uniform, the number of wavelengths and power uniformity may be difficult to control, resulting in power waste and unequal power distribution across different wavelength channels. In addition, the channel spacing of comb lasers is based on the cavity length, which may make it difficult to get wider channel spacing.

Disclosed herein are integrated lasers, integrated laser arrays, photonic devices, packages, and systems that aim to improve on one or more challenges described above. A laser or a laser array may be described as "integrated" if components of a laser or a laser array responsible for emitting light (e.g., III-V components) are implemented on a single support (e.g., a chip, a wafer, a die, or a substrate) as components responsible for transmitting and/or manipulating light (e.g., waveguides, gratings, or modulators). An individual laser of a laser array may include a light-emitter structure (also sometimes referred to as an "active region") and a waveguide, both arranged along a longitudinal axis of a laser/waveguide/light-emitter structure. The light-emitter structure may be used to emit light of a certain wavelength. The waveguide may be used to transmit light emitted by the light-emitter structure (e.g., to transmit light from the light-emitter structure to laser output. Gratings may be provided on the top/bottom surface and/or on the sidewalls of the waveguide to change the wavelength of the light emitted by the light-emitter structure to another wavelength as the light is being transmitted through the waveguide. Wavelength spacing of different lasers of a laser array may be defined with high precision by varying effective pitch of the gratings of different lasers or/and by varying effective widths (thus varying effective refractive indices) of the waveguides of different lasers. In particular, some embodiments of the present disclosure are based on implementing different lasers of a laser array using a technique that allows achieving sub-nanometer effective pitch resolution for the gratings even though the gratings are fabricated with a resolution of one nanometer or more. Other embodiments of the present disclosure are based on implementing different lasers of a laser array using a technique that includes varying effective widths of different lasers by implementing sidewall gratings on left and right sidewalls of the laser waveguides and by changing, from one laser to another, an offset between the sidewall gratings on the left sidewall and the sidewall gratings on the right sidewall to compensate for the changes in grating strength caused by the changes in the effective widths of different lasers. In some embodiments, these two techniques may be combined. Laser arrays forming according to either one or a combination of the techniques described herein may be an integrated laser array in that light-emitter structures of different lasers may be, or may include, III-V components, while waveguides and gratings may be Si components. As used herein, the term "Si components" refers to components of any materials other than III-V materials, with Si being one non-limiting example of such materials. Implementing wavelength control using Si components (e.g., controlling wavelength spacing after light has been emitted) may advantageously allow tighter control of laser channel spacing and power, compared to conventional approaches of implementing wavelength control using III-V components (e.g., controlling wavelength spacing of the light being emitted). Integrated laser arrays as described herein may be particularly suitable for being implemented as integrated DWDM laser arrays. Integrated laser arrays as described herein may be implemented as multi-wavelength laser arrays on Si with channel spacing being compliant with CW-wavelength division multiplexing (WDM) MSA (Continuous-Wave Wavelength Division Multiplexing Multi-Source Agreement) standards, may include Si components in the form of ring modulator arrays for multi-lane transmitter, and may be included in a transmitter architecture with integrated lasers and ring modulators. In some implementations, an entire optical transmitted with an integrated laser array as described herein may be implemented on a single support (e.g., on a single Si chip), which may eliminate the need for expensive and lossy coupling between the laser array and a separate transmitter chip.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

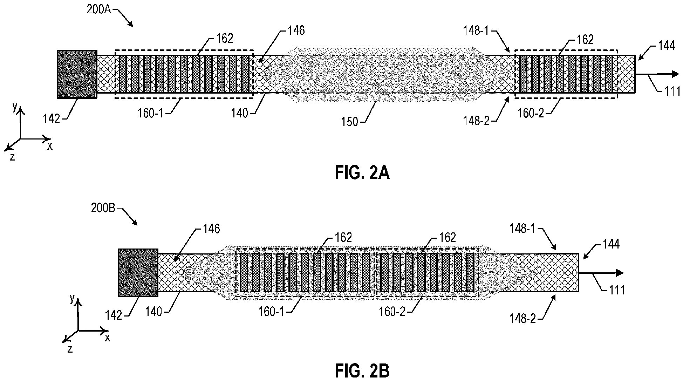

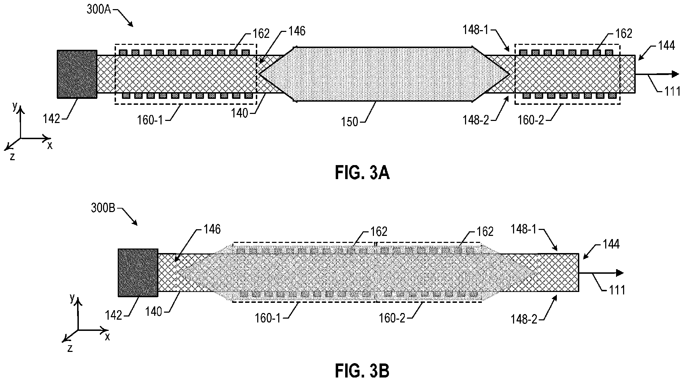

Any of the features discussed with reference to any of accompanying drawings herein may be combined with any other features to form a photonic device 100, a laser array 110, a laser 112, a microelectronic package 2200, or a computing device 2400, as appropriate. For convenience, the phrase "lasers 112" may be used to refer to a collection of lasers 112-1, 112-2, and so on, while the phrase "laser 112" may be used to refer to one of the lasers 112. Similarly, the phrase "modulators 122" may be used to refer to a collection of modulators 122-1, 122-2, and so on, while the phrase "modulator 122" may be used to refer to one of the modulators 122, etc. Also for convenience, a collection of drawings identified with letters in their figure numbers may be referred to without the letters, e.g., a collection of FIGS. 2A-2B may be referred to as "FIG. 2," a collection of FIGS. 3A-3B may be referred to as "FIG. 3," and so on. A number of elements of the drawings with same reference numerals may be shared between different drawings; for ease of discussion, a description of these elements provided with respect to one of the drawings is not repeated for the other drawings, and these elements may take the form of any of the embodiments disclosed herein. The drawings are not necessarily to scale. Although some of the drawings illustrate rectilinear structures with flat walls/surfaces and right-angle corners, this is simply for ease of illustration and may not reflect real-life process limitations which may cause various features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias, trenches, or other openings, inadvertent rounding of corners or variations in thicknesses of different material layers. There may be other defects not listed here but that are common within the field of semiconductor device fabrication and packaging. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of integrated laser arrays as described herein.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used to describe a range of dimensions, the phrase "between X and Y" represents a range that includes X and Y. When used to describe a location of an element, the phrase "between X and Y" represents a region that is spatially between element X and element Y. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 10%, e.g., within +/- 5% or within +/- 2%, of the exact orientation.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, the terms "package" and "integrated circuit (IC) package" are synonymous, as are the terms "die" and "IC die." Furthermore, the terms "chip," "chiplet," "die," and "IC die" may be used interchangeably herein.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

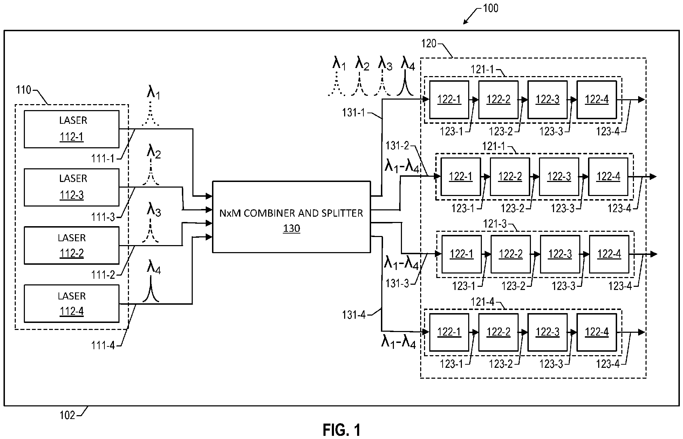

FIG. 1 is a schematic illustration of an example photonic device 100 with an integrated laser array, according to various embodiments. As shown in FIG. 1, the photonic device 100 may include a laser array 110 and a modulator array 120. As also shown in FIG. 1, the photonic device 100 may further include an NxM multiplexer 130 between the laser array 110 and the modulator array 120, wherein N is the number of inputs to the multiplexer 130, M is the number of outputs of the multiplexer 130, and N and M are integers greater than 1.

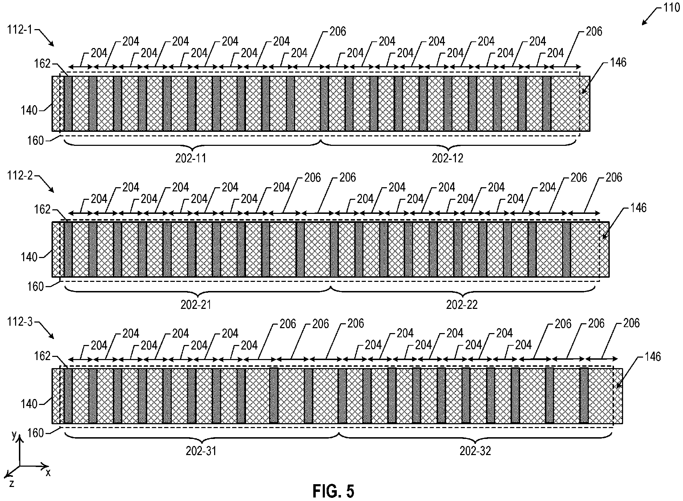

The laser array 110 may include N lasers 112, individually shown in FIG. 1 as a laser 112-1, a laser 112-2, a laser 112-3, and a laser 112-4. Thus, for the example of FIG. 1, N is equal to 4. However, while FIG. 1 and laser arrays 110 shown in subsequent drawings illustrate a certain number of lasers 112 (e.g., four lasers 112 are illustrated in FIG. 1, while three lasers 112 are illustrated in FIGS. 5-9), in various embodiments, a laser array 110 and/or a photonic device 100 may include any number N of two or more lasers 112. Each of the lasers 112-i is configured to output light at a certain distinct wavelength $\lambda_i$, where i is an integer between 1 and N that identifies one of the N lasers 112. For example, the laser 112-1 may output light of a wavelength $\lambda_1$, provided as an optical signal 111-1 at the output of the laser 112-1. The laser 112-2 may output light of a wavelength $\lambda_2$, provided as an optical signal 111-2 at the output of the laser 112-2. The laser 112-3 may output light of a wavelength $\lambda_3$, provided as an optical signal 111-3 at the output of the laser 112-3. The laser 112-4 may output light of a wavelength $\lambda_4$, provided as an optical signal 111-4 at the output of the laser 112-4. N inputs to the multiplexer 130 may be based on the N optical signals 111 provided at the outputs of the N lasers 112 of the laser array 110, as shown in FIG. 1. In some embodiments, spacing between the wavelengths A of the outputs 111 of different lasers 112 may be ranging from about 1 angstrom to about 50 nanometers, e.g., from sub-nanometer to about 30 nanometers, or between about 1 nanometer and 20 nanometers. In some embodiments, the wavelengths A of different lasers 112 may be in the range between about 1100 nanometers and about 1700 nanometers, e.g., about 1300 nanometers or about 1550 nanometers. In context of the present disclosure, a laser 112-i outputting light of a certain wavelength $\lambda_i$ may include a laser 112-i outputting light in a range of wavelengths with the wavelength $\lambda_i$ being the central wavelength of the range. In some embodiments, one or more of the lasers 112 may be implemented as distributed Bragg reflector (DBR) lasers (e.g., as shown in FIG. 2A, FIG. 3A, and FIG. 4A). In some embodiments, one or more of the lasers 112 may be implemented as distributed feedback (DFB) lasers (e.g., as shown in FIG. 2B, FIG. 3B, and FIG. 4B).

The multiplexer 130 may be an NxM combiner and splitter. To that end, the multiplexer 130 may be configured to combine the N optical signals 111 of different wavelengths $\lambda_1$ through $\lambda_N$, provided as N inputs to the multiplexer 130, into a single optical signal that is a multi-wavelength signal (i.e., a signal comprising wavelengths $\lambda_1$-$\lambda_N$). The multiplexer 130 may then provide optical signals 131 at M outputs of the multiplexer 130. The optical signals 131 provided at M outputs of the multiplexer 130 are individually shown in FIG. 1 as an optical signal 131-1, an optical signal 131-2, an optical signal 131-3, and an optical signal 131-4. Thus, for the example of FIG. 1, M is equal to 4. However, while FIG. 1 illustrates four output signals 131 at the outputs of the multiplexer 130, in various embodiments the photonic device 100 may include any number M of two or more output signals 131 output by the multiplexer 130. Each of the optical signals 131-j, provided at M outputs of the multiplexer 130, where j is an integer between 1 and M, may be a respective portion of the multi-wavelength signal with wavelengths $\lambda_1$-$\lambda_N$, combined from the N optical signals 111 provided at N inputs of the multiplexer 130. Thus, the multiplexer 130 may combine the N optical signals 111 of different wavelengths $\lambda_1$ through $\lambda_N$ into a single optical signal that is a multi-wavelength signal comprising wavelengths $\lambda_1$-$A_N$ and then split the single optical signal into M optical signals 131-j, provided at M outputs of the multiplexer 130. In various embodiments, the number M of the outputs of the multiplexer 130 may be, but does not have to be, equal to the number N of the inputs of the multiplexer 130. FIG. 1 schematically illustrates that each of the outputs 111 of the lasers 112 is an output having a single central wavelength by showing wavelength functions for the outputs 111-1 through 111-4 using, respectively, dotted, dash-dotted, dashed, and solid lines. FIG. 1 further schematically illustrates that each of the optical signals 131 is a signal combining (e.g., superimposing) the optical signals 111 of different wavelengths $\lambda_1$ through $\lambda_N$ by showing wavelength functions shown for the outputs 111-1 through 111-4 combined into one optical signal for the signal 131-1, and by labeling each of the other signals 131 as a signal $\lambda_1$-$\lambda_4$ (in order to not clutter the drawing).

The modulator array 120 may include a modulator arrangement 121 (e.g., a series) of N modulators 122 for each signal branch at the outputs of the multiplexer 130 (i.e., in a path for each of the optical signals 131). Individual modulator arrangements 121 are labeled in FIG. 1 as a modulator arrangement 121-1, a modulator arrangement 121-2, a modulator arrangement 121-3, and a modulator arrangement 121-4. The number of modulator arrangements 121 may be equal to the number M of the outputs of the multiplexer 130. The number of modulators 122 within a modulator arrangement 121 of a given branch of the modulator array 120 may be equal to the number N of the inputs to the multiplexer 130. A modulator arrangement 121 of a given branch of the modulator array 120 may include N modulators 122, individually labeled in FIG. 1 as a modulator 122-1, a modulator 122-2, a modulator 122-3, and a modulator 122-4. For a given optical signal 131-j, a modulator 122-i of the modulator arrangement 121-j is configured to modulate a portion corresponding to the optical signal 111-i within the optical signal 131-j provided as an input to the modulator arrangement 121-j. For example, for the optical signal 131-2, a modulator 122-1 of the modulator arrangement 121-2 is configured to modulate a portion corresponding to the optical signal 111-1 within the optical signal 131-2 provided as an input to the modulator arrangement 121-2, a modulator 122-2 of the modulator arrangement 121-2 is configured to modulate a portion corresponding to the optical signal 111-2 within the optical signal 131-2, a modulator 122-3 of the modulator arrangement 121-2 is configured to modulate a portion corresponding to the optical signal 111-3 within the optical signal 131-2, and a modulator 122-4 of the modulator arrangement 121-2 is configured to modulate a portion corresponding to the optical signal 111-4 within the optical signal 131-2. In some embodiments, there may be a one-to-one correspondence between the lasers 112 and the modulators 122 in each of the modulator arrangements 121, in that, for a given modulator arrangement 121-j, each laser 112 is associated with one and only one modulator 122, and vice versa.

Within a given modulator arrangement 121-j of the modulator array 120, the modulators 122 may apply modulation to the distinct wavelengths generated by the lasers 112 to generate a modulator output signal 123 that includes a combination (e.g., a superposition) of the signals of different wavelengths $\lambda_1$-$\lambda_N$. In some embodiments, the modulators 122 may be wavelength-selective modulators, which means that a modulator 122-i may receive as an input an optical signal that includes multiple central wavelengths (e.g., wavelengths $\lambda_1$ - $\lambda_4$), but only apply modulation to a portion of the optical signal for which the carrier wavelength is that of the output signal 111-i of the associated laser 112-i. For example, for a given modulator arrangement 121-j, the modulator 122-1 may receive as an input the wavelength combiner output 131-j that is a combination of optical signals corresponding to the wavelengths $\lambda_1$ - $\lambda_4$ (when N=4), apply modulation to a portion of the wavelength combiner output 131-j corresponding to the wavelength $\lambda_1$ of the optical signal 111-1 to generate a modulated portion of the wavelength combiner output 131-j corresponding to the wavelength $\lambda_1$, and pass portions of the wavelength combiner output 131-j corresponding to the wavelengths $\lambda_2$- $\lambda_4$ (e.g., corresponding to the optical signals 111-2 through 111-4) without modulation. Thus, a modulator output 123-1 of a modulator 122-1 of a given modulator arrangement 121-j is a combination of a modulated portion of the wavelength combiner output 131-j corresponding to the wavelength $\lambda_1$ and unmodulated portions of the wavelength combiner output 131-j corresponding to the wavelengths $\lambda_2$ - $\lambda_4$. After that, the modulator 122-2 may receive as an input the modulator output 123-1 from the modulator 122-1, apply modulation to a portion of the wavelength combiner output 131-j corresponding to the wavelength $\lambda_2$ of the optical signal 111-2 to generate a modulated portion of the wavelength combiner output 131-j corresponding to the wavelength $\lambda_2$, and pass portions of the wavelength combiner output 131-j corresponding to the wavelengths $\lambda_3$ - $\lambda_4$ (e.g., corresponding to the optical signals 111-3 through 111-4) without modulation, as well as passing without modulation the modulated portion of the wavelength combiner output 131-j corresponding to the wavelength $\lambda_1$ that was generated by the modulator 122-1. Thus, a modulator output 123-2 of the modulator 122-2 is a combination of a modulated portion of the wavelength combiner output 131-j corresponding to the wavelength $\lambda_1$ generated by the modulator 122-1, a modulated portion of the wavelength combiner output 131-j corresponding to the wavelength $\lambda_2$ generated by the modulator 122-2, and unmodulated portions of the wavelength combiner output 131-j corresponding to the wavelengths $\lambda_3$-$\lambda_4$. In other words, a modulator output 123-2 of the modulator 122-2 is a combination of an unmodulated portion of the modulator output 123-1 corresponding to the wavelength $\lambda_1$, a modulated portion of the wavelength combiner output 131-j corresponding to the wavelength $\lambda_2$ generated by the modulator 122-2, an unmodulated portion of the wavelength combiner output 131-j corresponding to the wavelength $\lambda_3$, and an unmodulated portion of the wavelength combiner output 131-j corresponding to the wavelength $\lambda_4$. Next, the modulator 122-3 may receive as an input the modulator output 123-2 from the modulator 122-2, apply modulation to a portion of the wavelength combiner output 131-j corresponding to the wavelength $\lambda_3$ of the optical signal 111-3 to generate a modulated portion of the wavelength combiner output 131-j corresponding to the wavelength $\lambda_3$, and pass a portion of the wavelength combiner output 131-j corresponding to the wavelength $\lambda_4$ (e.g., corresponding to the optical signal 111-4) without modulation, as well as passing without modulation the modulated portion of the wavelength combiner output 131-j corresponding to the wavelength $\lambda_1$ that was generated by the modulator 122-1 and the modulated portion of the wavelength combiner output 131-j corresponding to the wavelength $\lambda_2$ that was generated by the modulator 122-2. Thus, a modulator output 123-3 of the modulator 122-3 is a combination of a modulated portion of the wavelength combiner output 131-j corresponding to the wavelength $\lambda_1$ generated by the modulator 122-1, a modulated portion of the wavelength combiner output 131-j corresponding to the wavelength $\lambda_2$ generated by the modulator 122-2, a modulated portion of the wavelength combiner output 131-j corresponding to the wavelength $\lambda_3$ generated by the modulator 122-3, and unmodulated portion of the wavelength combiner output 131-j corresponding to the wavelength $\lambda_4$. In other words, a modulator output 123-3 of the modulator 122-3 is a combination of an unmodulated portion of the modulator output 123-1 corresponding to the wavelength $\lambda_1$, an unmodulated portion of the modulator output 123-2 corresponding to the wavelength $\lambda_2$, and a modulated portion of the wavelength combiner output 131-j corresponding to the wavelength $\lambda_3$ generated by the modulator 122-3, and unmodulated portion of the wavelength combiner output 131-j corresponding to the wavelength $\lambda_4$. Finally, the modulator 122-4 may receive as an input the modulator output 123-3 from the modulator 122-3, apply modulation to a portion of the wavelength combiner output 131-j corresponding to the wavelength $\lambda_4$ of the optical signal 111-4 to generate a modulated portion of the wavelength combiner output 131-j corresponding to the wavelength $\lambda_4$, and pass the portions of the modulator output 123-3 corresponding to the wavelengths $\lambda_1$ - $\lambda_3$ without modulation. Thus, a modulator output 123-4 of the modulator 122-4 is a combination of a modulated portion of the wavelength combiner output 131-j corresponding to the wavelength $\lambda_1$ generated by the modulator 122-1, a modulated portion of the wavelength combiner output 131-j corresponding to the wavelength $\lambda_2$ generated by the modulator 122-2, a modulated portion of the wavelength combiner output 131-j corresponding to the wavelength $\lambda_3$ generated by the modulator 122-3, and a modulated portion of the wavelength combiner output 131-j corresponding to the wavelength $\lambda_4$ generated by the modulator 122-4. In other words, a modulator output 123-4 of the modulator 122-4 is a combination of an unmodulated portion of the modulator output 123-1 corresponding to the wavelength $\lambda_1$, an unmodulated portion of the modulator output 123-2 corresponding to the wavelength $\lambda_2$, an unmodulated portion of the modulator output 123-3 corresponding to the wavelength $\lambda_3$, and a modulated portion of the wavelength combiner output 131-j corresponding to the wavelength $\lambda_4$ generated by the modulator 122-4.

Different ways of implementing modulators 122 are known in the art, all of which being within the scope of the present disclosure. For example, in some embodiments, modulators 122 may be implemented as ring modulators, e.g., as wavelength-selective ring modulators. Different ways of implementing a multiplexer 130 are known in the art, all of which being within the scope of the present disclosure. For example, in some embodiments, a multiplexer 130 may be include an Mach-Zehnder Interferometric (MZI). In some embodiments, one or more of the modulators 122 and/or the multiplexer 130 may be implemented as Si components.

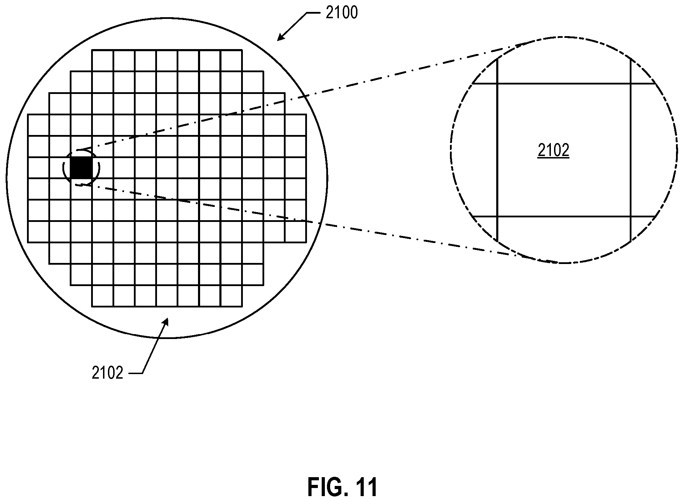

Implementations of the present disclosure may be formed or carried out on any suitable support 102, such as a substrate, a die, a wafer, or a chip. The support 102 may, e.g., be the wafer 2100 of FIG. 11, discussed below, and may be, or be included in, a die, e.g., the singulated die 2102 of FIG. 11, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials, group II-VI materials (i.e., materials from groups II and VI of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. In some embodiments, the support 102 may be, or may include, a glass core. As used herein, the term "glass core" refers to a structure (e.g., a portion of a glass layer) of any glass material such as quartz, silica, fused silica, silicate glass (e.g., borosilicate, aluminosilicate, aluminoborosilicate), soda-lime glass, soda-lime silica, borofloat glass, lead borate glass, photosensitive glass, non-photosensitive glass, or ceramic glass. In particular, the glass core may refer to bulk glass or a solid volume of glass, as opposed to, e.g., materials that may include particles of glass, such as glass fiber reinforced polymers. Such glass materials are typically non-crystalline, often transparent, amorphous solids. In some embodiments, a glass core may be an amorphous solid glass layer. In some embodiments, a glass core may include silicon and oxygen, as well as any one or more of aluminum, boron, magnesium, calcium, barium, tin, sodium, potassium, strontium, phosphorus, zirconium, lithium, titanium, and zinc. In some embodiments, a glass core may include a material, e.g., any of the materials described above, with a weight percentage of silicon being at least about 0,5%, e.g., between about 0,5% and 50%, between about 1% and 48%, or at least about 23%. For example, if a glass core is fused silica, the weight percentage of silicon may be about 47%. In some embodiments, a glass core may include at least 23% silicon and at least 26% oxygen by weight, and, in some further embodiments, such a glass core may further include at least 5% aluminum by weight. In some embodiments, a glass core may include any of the materials described above and may further include one or more additives such as aluminum and oxygen (e.g., $Al_2O_3$), boron and oxygen (e.g., $B_2O_3$), magnesium and oxygen (e.g., MgO), calcium and oxygen (e.g., CaO), strontium and oxygen (e.g., SrO), barium and oxygen (e.g., BaO), tin and oxygen (e.g., $SnO_2$), sodium and oxygen (e.g., $Na_2O$), potassium and oxygen (e.g., $K_2O$), phosphorous and oxygen (e.g., $P_2O_3$), zirconium and oxygen (e.g., $ZrO_2$), lithium and oxygen (e.g., $Li_2O$), titanium (e.g., Ti), and zinc (Zn). Although a few examples of materials from which the support 102 may be formed are described here, any material that may serve as a foundation upon which integrated laser arrays as described herein may be built falls within the spirit and scope of the present disclosure.

In some embodiments, the lasers 112 of the laser array 110 may be implemented on a single support 102. In some embodiments, the modulators 122 and the multiplexer 130 may be implemented on the same support 102 as the lasers 112, as illustrated in FIG. 1. However, in other embodiments, one or more of the modulators 122 and/or the multiplexer 130 may be implemented on a different support than the support 102 with the lasers 112.

The photonic device 100 may be particularly advantageous if used as a part of a DWDM system, but is not limited to DWDM systems. The arrangement of the multiplexer 130, the modulator array 120, and various modulators 122 of the photonic devices 100 as shown in FIG. 1 is not the only arrangement in which an integrated laser array 110 as described herein may be implemented, but merely provides one example of such a photonic device. The number and positions of various elements shown in FIG. 1 is purely illustrative and, in various other embodiments, other numbers of these elements, provided in other locations relative to one another may be used.

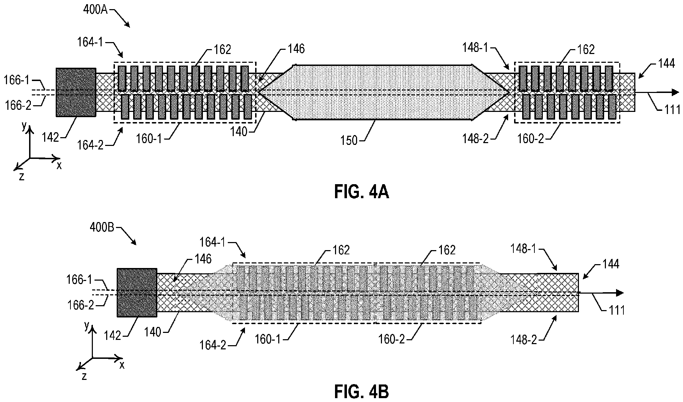

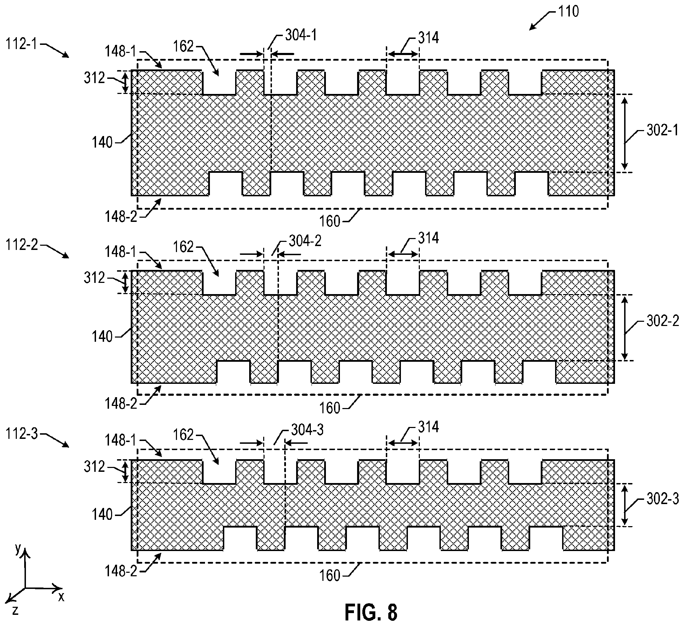

Turning to the details of integrated laser arrays 110, description of these details is arranged as follows. First FIGS. 2-4 illustrate examples of lasers of different types and with different types of gratings. In particular, two different types of lasers are illustrated, one being a DBR laser as shown in FIGS. 2A, 3A, and 4A, and the other one being a DFB laser as shown in FIGS. 2B, 3B, and 4B. The different types of gratings illustrated in FIGS. 2-4 are surface gratings as shown in FIGS. 2A-2B for two different types of lasers, sidewall gratings as shown in FIGS. 3A-3B for two different types of lasers, and surface and sidewall gratings as shown in FIGS. 4A-4B for two different types of lasers. Each of FIGS. 2A, 2B, 3A, 3B, 4A, and 4B illustrates a laser that may be an example of any of the lasers 112 of the laser array 110. On the other hand, each of FIGS. 5-10 illustrates an example of a laser array 110 with three lasers 112 (labeled individually as lasers 112-1, 112-2, and 112-3) in order to show the differences between different lasers 112 of a laser array 110. In particular, FIGS. 5-7 illustrate lasers 112-1 through 112-3 with surface gratings of different effective pitches, while FIGS. 8-10 illustrate lasers 112-1 through 112-3 with sidewall gratings and waveguides of different effective widths. In further embodiments, lasers 112 of a laser array 110 may be implemented with surface gratings of different effective pitches as shown in FIGS. 5-7 as well as sidewall gratings and waveguides of different effective widths as shown in FIGS. 8-10. Examples of such embodiments as shown in FIGS. 4A, 4B for, respectively, a DBR laser and a DFB laser.

FIGS. 2A-2B are top-down views of two example lasers with surface gratings, according to various embodiments. FIG. 2A illustrates a laser 200A, which is an example of a DBR laser with surface gratings, while FIG. 2B illustrates a laser 200A, which is an example of a DFB laser with surface gratings. Together, lasers 200A and 200B may be referred to as "lasers 200," each being one example implementation of any one of the lasers 112 of the any of the laser arrays 110 described herein.

As shown in FIGS. 2A-2B, a laser 200 may include a waveguide 140 having a backside termination 142 at one end and an output 144 at the other end, a light-emitter structure 150 aligned along a longitudinal axis of the waveguide 140, and at least one of a back grating 160-1, and a front grating 160-2, also aligned along a longitudinal axis of the waveguide 140. FIGS. 2A-2B as well as FIGS. 3-10 illustrate a coordinate system x-y-z in order to describe different directions and planes in terms of the directions and planes of the same coordinate system. As used herein, the x-axis is an axis along which the longitudinal axis of the waveguide 140 extends, which is also the direction of propagation of light through the waveguide 140 (e.g., in FIGS. 2A-2B, the arrow representing the optical signal 111 output by the laser 200 may also be seen as the longitudinal axis of the waveguide 140). Furthermore, as used herein, an x-y plane is a plane of a top-down view of the lasers shown in FIGS. 2-10, while an x-z plane is a plane of a cross-sectional side view of the lasers shown in FIGS. 2-10.

The light-emitter structure 150 is shown in FIGS. 2A-2B as being a semi-transparent structure superimposed over the waveguide 140 to represent that, in some embodiments, the light-emitter structure 150 may be provided above the waveguide 140 (i.e., further away from a support over which the waveguide 140 is provided, e.g., the support 102 described above), while, in other embodiments, the light-emitter structure 150 may be provided below the waveguide 140 (i.e., closer to the support over which the waveguide 140 is provided). As shown in FIGS. 2A-2B, in some embodiments, a longitudinal axis of the waveguide 140 may be parallel to a longitudinal axis of the light-emitter structure 150. In general, the light-emitter structure 150 may include any structure known in the art that can emit light in lasers. For example, in some embodiments, the light-emitter structure 150 may include an active region, e.g., an active region comprising a III-V material, configured to emit light of a certain wavelength. Thus, such a light-emitter structure 150 may be an example of a III-V component. In some embodiments, the light-emitter structures 150 of different lasers 112 of a laser array 110 may emit light of about the same wavelengths, and gratings 160 may be used to change the wavelengths of the emitted light so that the wavelengths A of the outputs 111 of different lasers 112 are different. In other embodiments, the light-emitter structures 150 of at least some of the lasers 112 of a laser array 110 may emit light of different wavelengths. In such embodiments, the gratings 160 may still be used to change the wavelengths of the emitted light.

The waveguide 140 may be any waveguide configured to support propagation of light emitted by the light-emitter structure 150 between the backside termination 142 and the output 144 so that the laser 200 may output the optical signal 111 from the output 144. In general, the waveguide 140 may include any waveguide structure known in the art that can support propagation of light in lasers. For example, in some embodiments, the waveguide 140 may include an insulator/dielectric material, e.g., a material comprising a semiconductor material (e.g., Si) and nitrogen (N), e.g., SiN. Thus, such a waveguide 140 may be an example of a Si component.

As used herein, the terms "top surface" and "bottom surface" of a waveguide 140 refer to boundaries/faces of the waveguide that are substantially parallel to the support over which a laser with the waveguide 140 is provided (e.g., the support 102, described above). For example, the top and bottom surfaces of a waveguide 140 may be two surfaces of the waveguide 140 that are in two different (opposing) x-y planes of the example coordinate system shown. The top and bottom surfaces of the waveguide 140 may also be referred to as the top and bottom "faces" of a waveguide 140. FIGS. 2A-2B and some of the subsequent drawings illustrate a top surface as a surface 146. On the other hand, the term "sidewalls" of a waveguide 140 refer to boundaries/faces that extend between the top and bottom surfaces of the waveguide 140 and are substantially parallel to the longitudinal axis of the waveguide 140. For example, the sidewalls of a waveguide 140 may be two surfaces of the waveguide 140 that are in two different (opposing) x-z planes of the example coordinate system shown. FIGS. 2A-2B and some of the subsequent drawings illustrate sidewalls of the waveguide 140 as left and right sidewalls 148-1 and 148-2 (collectively referred to as "sidewalls 148"). It should be noted that, in some embodiments, the sidewalls 148 may not necessarily be in planes perpendicular to the support 102, e.g., due to manufacturing processes used to fabricate the waveguide 140 the sidewalls 148 may be tapered. Therefore, the sidewalls 148 may be described as surfaces of the waveguide 140 that extend parallel to the longitudinal axis of the waveguide 140 (i.e., parallel to the direction of propagation of light through the waveguide 140) and not parallel to the support 102 over which a laser is provided. It should be noted that all descriptions provided herein with respect to gratings on the top surface 146 are equally applicable to gratings provided on the bottom surface of the waveguide 140.

As used herein, the term "width" of a waveguide 140 refers to the distance between the first and second sidewalls of the waveguide 140, e.g., a dimension of the waveguide 140 in a direction parallel to the support 102 and perpendicular to the longitudinal axis of the waveguide 140 (e.g., a dimension of the waveguide 140 measured along the y-axis of the example coordinate system shown in the present drawings). As used herein, the term "length" of a waveguide 140 refers to a dimension of the waveguide 140 in the direction of the longitudinal axis of the waveguide 140, e.g., a dimension of the waveguide 140 in a direction parallel to the support 102 and parallel to the direction of propagation of light through the waveguide 140 (e.g., a dimension of the waveguide 140 measured along the x-axis of the example coordinate system shown in the present drawings). As used herein, the term "thickness" of a waveguide 140 refers to the distance between the top and bottom faces of the waveguide 140, e.g., a dimension of the waveguide 140 in a direction perpendicular to the support (e.g., a dimension of the waveguide 140 measured along the z-axis of the example coordinate system shown in the present drawings).

The gratings 160-1 and 160-2 (collectively referred to as "gratings 160") may be provided on the top surface or/and the bottom surface of the waveguide 140 to modify the wavelength of light emitted by the light-emitter structure 150 so that the optical signal 111 emerging from the output 144 has the desired wavelength for the laser 200. In some embodiments, the gratings 160 may be used to modify the phase of light emitted by the light-emitter structure 150 so that the optical signal 111 emerging from the output 144 has the desired phase for the laser 200. The lasers 200A and 200B differ in the location of the gratings with respect to the light-emitter structure 150. In particular, for a DBR laser as shown with the laser 200A, the gratings 160-1 and 160-2 may be provided on portions of the waveguide 140 on either end of the light-emitter structure 150, while for a DFB laser as shown with the laser 200B, the gratings 160-1 and 160-2 may be provided on portions of the waveguide 140 that are below or above the light-emitter structure 150. In other words, for the laser 200A, a footprint (e.g., a projection on an x-y plane, or a projection on the plane of a support over which the laser is provided) of the light-emitter structure 150 may at least partially, or fully, overlap with a footprint of the gratings 160, while for the laser 200B, a footprint of the light-emitter structure 150 may be adjacent (in the direction parallel to the longitudinal axis of the waveguide 140) to a footprint of the grating 160-1 and adjacent to a footprint of the grating 160-2. While both gratings 160-1 and 160-2 are shown in FIGS. 2A-2B, in some embodiments, one of these gratings may be replaced with another reflective element such as a mirror, as known in the art.

In general, a grating 160 may be a set of perturbations 162 on a surface or a sidewall of a waveguide 140, as illustrated in FIGS. 2A-2B. The perturbations 162 may be elongated perturbations, and each of the elongated perturbations 162 may extend in a direction substantially perpendicular to the longitudinal axis of the waveguide 140. In some embodiments, the perturbations 162 may be in the form of trenches, while in other embodiments, the perturbations 162 may be in the form of ridges. FIGS. 2A-2B illustrate embodiments where the gratings 160 are surface gratings and, therefore, the perturbations 162 are on the top surface 146 of the waveguide 140. Thus, the perturbations 162 of the waveguides 140 of FIGS. 2A-2B extend in the direction of the y-axis, between the sidewalls 148-1 and 148-2.

FIGS. 3A-3B are top-down views of two example lasers with sidewall gratings, according to various embodiments. FIG. 3A illustrates a laser 300A, which is an example of a DBR laser with sidewall gratings, while FIG. 3B illustrates a laser 300A, which is an example of a DFB laser with sidewall gratings. Together, lasers 300A and 300B may be referred to as "lasers 300," each being one example implementation of any one of the lasers 112 of the any of the laser arrays 110 described herein. The lasers 300A and 300B are substantially the same as the lasers 200A and 200B, respectively, but the gratings 160 of the lasers 300 are sidewall gratings. Therefore, in FIGS. 3A-3B, the perturbations 162 are on the left sidewall 148-1 and the right sidewall 148-2 of the waveguide 140. Thus, the perturbations 162 of the waveguides 140 of FIGS. 3A-3B extend in the direction of the z-axis, between the bottom surface and the top surface 146 of the waveguide 140. In some embodiments of sidewall gratings, the perturbations 162 on one sidewall 148 may be offset, in a direction parallel to the longitudinal axis of the waveguide 140, with respect to the perturbations 162 on the other sidewall 148 (e.g., as shown with offsets 304 illustrated in FIGS. 8-10 and described in greater detail below).

FIGS. 4A-4B are top-down views of two example lasers with surface and sidewall gratings, according to various embodiments. FIG. 4A illustrates a laser 400A, which is an example of a DBR laser with surface and sidewall gratings, while FIG. 4B illustrates a laser 400A, which is an example of a DFB laser with surface and sidewall gratings. Together, lasers 400A and 400B may be referred to as "lasers 400," each being one example implementation of any one of the lasers 112 of the any of the laser arrays 110 described herein. The lasers 400A and 400B are substantially the same as the lasers 300A and 300B, respectively, but the gratings 160 of the lasers 400 are sidewall gratings as those of the lasers 300 and further extending partially over the top surface 146, similar to the gratings 160 of the lasers 200. As shown in FIGS. 4A-4B, a first set 164-1 of the perturbations 162 (which may be described as "first perturbations" or "first elongated perturbations") extends in a direction perpendicular to a longitudinal axis of the waveguide 140 (in other words, the perturbations 162 of the first set 164-1 extend in a direction perpendicular to the direction of propagation of light emitted by the light-emitter structure 150) from a first line 166-1 on the top surface 146 of the waveguide 140 to a closest edge (e.g., a top) of the first sidewall 148-1 and further extending from the closest edge of the first sidewall 148-1 towards an opposite edge (e.g., a bottom) of the first sidewall 148-1, e.g., all the way down to the bottom face of the waveguide 140. As also shown in FIGS. 4A-4B, a second set 164-2 of the perturbations 162 (which may be described as "second perturbations" or "second elongated perturbations") extends in a direction perpendicular to a longitudinal axis of the waveguide 140 (in other words, the perturbations 162 of the second set 164-2 extend in a direction perpendicular to the direction of propagation of light emitted by the light-emitter structure 150) from a second line 166-2 on the top surface 146 of the waveguide 140 to a closest edge (e.g., a top) of the second sidewall 148-2 and further extending from the closest edge of the second sidewall 148-2 towards an opposite edge (e.g., a bottom) of the second sidewall 148-2, e.g., all the way down to the bottom face of the waveguide 140. In some embodiments, the first line 166-1 and/or the second line 166-2 may be substantially parallel to the longitudinal axis of the waveguide 140 and be at a non-zero distance from one another. In some embodiments, the non-zero distance between the first and second lines 166 may be less than about 50% of an effective width of the waveguide, e.g., less than about 25%, or less than about 10%. Similar to the gratings 160 of FIGS. 3A-3B, in FIGS. 4A-4B the perturbations 162 of the second set 164-2 may be offset from the perturbations 162 of the first set 164-1 in the direction parallel to the longitudinal axis of the waveguide 140.

As described above, all descriptions provided herein with respect to gratings on the top surface 146 are equally applicable to gratings provided on the bottom surface of the waveguide 140. This means that FIGS. 2A-2B may be seen as illustrating embodiments of the lasers 200 where the perturbations 162 of the gratings 160 are on the bottom surface of the waveguide 140 (i.e., the surface closer to the support 102 than the top surface 146). This also means that FIGS. 4A-4B may be seen as illustrating embodiments of the lasers 400 that are substantially the same as the lasers 300 where the gratings 160 of the lasers 400 are sidewall gratings as those of the lasers 300, but where the gratings 160 further extend partially over the bottom surface of the waveguide 140, similar to the gratings 160 of the lasers 200 implemented on the bottom surface of the waveguide 140.

Conventionally, elongated perturbations of a grating are periodic, which means that a pitch (e.g., center-to-center distance between adjacent perturbations) is the same for all pairs of adjacent perturbations. The wavelength A of DBR or DFB lasers depends on the pitch ($\Delta$) of a grating on a waveguide and effective refractive index ($n_{eff}$) of the waveguide and the surrounding medium, as described in the equation below:

$$\lambda = 2\, n_{eff}\, \Delta$$

The change in the laser wavelength may be primarily controlled through the pitch of the grating, and the difference in the output wavelengths of the different lasers of a laser array may be controlled through the difference in the pitch. Hence, the channel spacing is limited to the resolution of the fabricated laser pitch. For a channel spacing of 100 GHz, the difference in the pitch must be about 1 angstrom, which may be extremely difficult, if not impossible, to achieve even in the most advanced silicon fabrication facilities. To circumvent the requirement of sub-nanometer difference in grating pitch, a technique that allows achieving sub-nanometer effective pitch resolution for the gratings even though the gratings are fabricated with a resolution of one nanometer or more may be implemented. This technique is illustrated in FIGS. 5-7.

Each of FIGS. 5-7 illustrates a laser array 110 as described above, where the laser array 110 includes three lasers 112. Again, the number of lasers 112 here is just an example, and in other embodiments of the laser array 110 as described with reference to FIGS. 5-7, the laser array 110 may include only two lasers 112 or more than three lasers 112. Only the waveguides 140 and the gratings 160 are shown for each of the lasers 112 of FIGS. 5-7 in order to illustrate the difference in how the gratings 160 are implemented for different lasers 112 while not obscuring the drawings with the details of other components of the lasers 112 such as the light-emitter structures 150 or the backside termination 142. For each laser 112 and each of FIGS. 5-7, a portion of the waveguide 140 with the grating 160 as shown may be a portion of the waveguide 140 with a back grating 160-1 or a portion of the waveguide 140 with a front grating 160-2 as described with reference to FIGS. 2-4, and may be implemented either adjacent to the light-emitter structure 150 as described with reference to FIGS. 2A, 3A, and 4A, or partially or fully overlapping with the light-emitter structure 150 as described with reference to FIGS. 2B, 3B, and 4B. FIGS. 5-7 are described with reference to the gratings 160 being surface gratings implemented on the top surface 146 of the waveguides 140, but these descriptions are equally applicable to the gratings 160 being surface gratings implemented on the bottom surface of the waveguides 140.

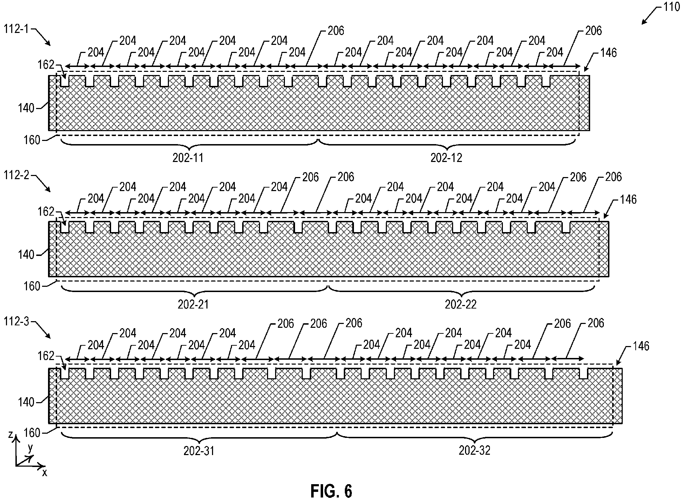

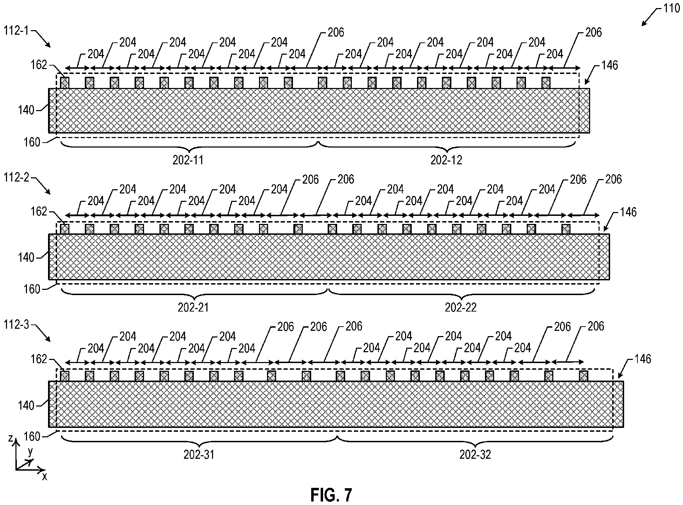

FIG. 5 illustrates top-down views of the waveguides 140 with surface gratings 160 (e.g., gratings on the top surface 146 of the waveguides 140) of different effective pitches that may be used in different lasers 112 of an integrated laser array 110, according to an embodiment. FIG. 6 illustrates cross-sectional side views of the waveguides 140 of FIG. 5 with perturbations 162 of the gratings 160 being implemented as trenches, according to an embodiment. FIG. 7 illustrates cross-sectional side views of the waveguides 140 of FIG. 5 with perturbations 162 of the gratings 160 being implemented as ridges, according to an embodiment.

As shown in FIG. 5, the gratings 160 of different lasers 112 may include a plurality of super-cells 202, shown as a first super-cell 202-11 and a second super-cell 202-12. Each super-cell 202 may include a first set of elongated perturbations 162 having a first pitch and a second set of elongated perturbations 162 having a second pitch that is different from the first pitch. For example, for the laser 112-1, the super-cell 202-11 includes 10 perturbations 162 with a first pitch 204 (the first 10 left-most perturbations shown in FIG. 5 for the laser 112-1), and the first perturbation of the super-cell 202-12 is provided at a second pitch 206 from the last perturbation of the super-cell 202-11 with the first pitch 204. Thus, for the super-cell 202-11, there are 9 grating periods with the first pitch 204 and 1 grating period with the second pitch 206. For the laser 112-2, the super-cell 202-21 includes 9 perturbations 162 with the first pitch 204 (the first 9 left-most perturbations shown in FIG. 5 for the laser 112-2), 1 perturbation with the second pitch 204, and the first perturbation of the super-cell 202-22 is also provided at the second pitch 206 from the last perturbation of the super-cell 202-21. Thus, for the super-cell 202-21, there are 8 grating periods with the first pitch 204 and 2 grating periods with the second pitch 206. For the laser 112-3, the super-cell 202-31 includes 8 perturbations 162 with the first pitch 204 (the first 9 left-most perturbations shown in FIG. 5 for the laser 112-2), 2 perturbations with the second pitch 204, and the first perturbation of the super-cell 202-32 is also provided at the second pitch 206 from the last perturbation of the super-cell 202-31. Thus, for the super-cell 202-31, there are 8 grating periods with the first pitch 204 and 2 grating periods with the second pitch 206. Although not specifically shown in the present drawings, a single grating 160 may include many more super-cells 202 than just two shown for each of the lasers 112 of FIGS. 5-7, e.g., hundreds of super-cells 202. A definition of a super-cell 202 may be shifted by one or more perturbations 162 to the right compared to what is shown in FIGS. 5-7, which would still leave the same number of grating periods with the first pitch 204 and with the second pitch 206 for each of the lasers 112 as described above, and which would still leave that the number of perturbations 162 with the first pitch 204 is different in different lasers 112 of the laser array 110, and that the number of perturbations 162 with the second pitch 206 is different in different lasers 112 of the laser array 110.

An effective pitch of a grating may be defined as an average of all pitches of the grating. When the super-cells 202 of a given laser 112 are substantially the same, an effective pitch of a grating 160 with a plurality of super-cells 202 is substantially the same as an effective pitch of a super-cell 202. For example, consider that the first pitch 204 is 201 nanometers and the second pitch 206 is 202 nanometers. In this case, the effective pitch of the super-cells 202 of the laser 112-1 is 201.1 nanometers, the effective pitch of the super-cells 202 of the laser 112-2 is 201.2 nanometers, and the effective pitch of the super-cells 203 of the laser 112-3 is 201.3 nanometers. In this manner, although first and second pitches 204, 206 are quite large and the resolution of the perturbations 162 of the gratings 160 of all lasers 112 is at least 1 nanometer, the difference in the effective grating pitch from one laser 112 to the next may be less than 1 nanometer (1 angstrom for this example). These values are only exemplary, and considerations described herein may be applied to laser arrays with different values for the first and second pitches 204, 206, and different numbers of perturbations 162 in the set of perturbations of the first pitch 204 and/or the set of perturbations of the second pitch 206. In various embodiments, each of the first pitch 204 and the second pitch 206 may be greater than about 50 nanometers, e.g., greater than about 100 nanometers, greater than about 150 nanometers, or greater than about 200 nanometers. In various embodiments, the second pitch 206 may be different from the first pitch 204 by less than about 8 angstroms, e.g., by less than about 5 angstroms, or by about 1 angstrom. In various embodiments, a difference in center-to-center distances of any two pairs of adjacent (e.g., nearest-neighbor) perturbations 162 of the grating 160 of one of the lasers 112 and of another one lasers 112 may be equal to or greater than about 1 nanometer, meaning that the perturbations 162 of all of the gratings of the laser array 110 shown in FIGS. 5-7 are fabricated with a resolution of at least 1 nanometer, which is feasible with current fabrication techniques and facilities.

The top-down view of FIG. 5 illustrates that the perturbations 162 are elongated perturbations having their long axis, or extending in a direction, perpendicular to the longitudinal axis of the waveguide 140. In other words, the perturbations 162 of the laser array 110 described with reference to FIGS. 5-7 extend in a direction perpendicular to the direction of propagation of light emitted by the light-emitter structure 150.

FIG. 6 illustrates that the perturbations 162 may be implemented as trenches in some embodiments. Such trenches may extend from the top surface 146 into the waveguide 140 to a certain depth that is smaller than the thickness of the waveguide 140. In some embodiments, the depth of the trenches of the perturbations 162 may be less than about 75% of the thickness of the waveguide 140, e.g., less than about 50% of the thickness of the waveguide 140, or less than about 25% of the thickness of the waveguide 140.

FIG. 7 illustrates that the perturbations 162 may be implemented as ridges in some embodiments. Such ridges may extend away from the top surface 146 of the waveguide 140 to a certain height. In some embodiments, the height of the ridges of the perturbations 162 may be at least about 5% of the thickness of the waveguide 140, e.g., at least about 15% of the thickness of the waveguide 140, or at least about 25% of the thickness of the waveguide 140.

FIGS. 5-7 illustrate changing the wavelength A of different lasers 112 by changing the effective pitch ($\Delta$) of a grating on a waveguide. On the other hand, FIGS. 8-10 illustrate changing the wavelength A of different lasers 112 by changing the width of a waveguide, which changes the effective refractive index ($n_{eff}$) of the waveguide.

Each of FIGS. 8-10 illustrates a laser array 110 as described above, where the laser array 110 includes three lasers 112. Again, the number of lasers 112 here is just an example, and in other embodiments of the laser array 110 as described with reference to FIGS. 8-10, the laser array 110 may include only two lasers 112 or more than three lasers 112. Only the waveguides 140 and the gratings 160 are shown for each of the lasers 112 of FIGS. 8-10 in order to illustrate the difference in how the gratings 160 are implemented for different lasers 112 while not obscuring the drawings with the details of other components of the lasers 112 such as the light-emitter structures 150 or the backside termination 142. For each laser 112 and each of FIGS. 8-10, a portion of the waveguide 140 with the grating 160 as shown may be a portion of the waveguide 140 with a back grating 160-1 or a portion of the waveguide 140 with a front grating 160-2 as described with reference to FIGS. 2-4, and may be implemented either adjacent to the light-emitter structure 150 as described with reference to FIGS. 2A, 3A, and 4A, or partially or fully overlapping with the light-emitter structure 150 as described with reference to FIGS. 2B, 3B, and 4B. FIGS. 8-10 are described with reference to the gratings 160 being sidewall gratings implemented on both sidewalls 148 (i.e., left and right sidewalls) of the waveguides 140, but these descriptions are equally applicable to the gratings 160 being implemented on only one of the sidewalls 148 of the waveguides 140.

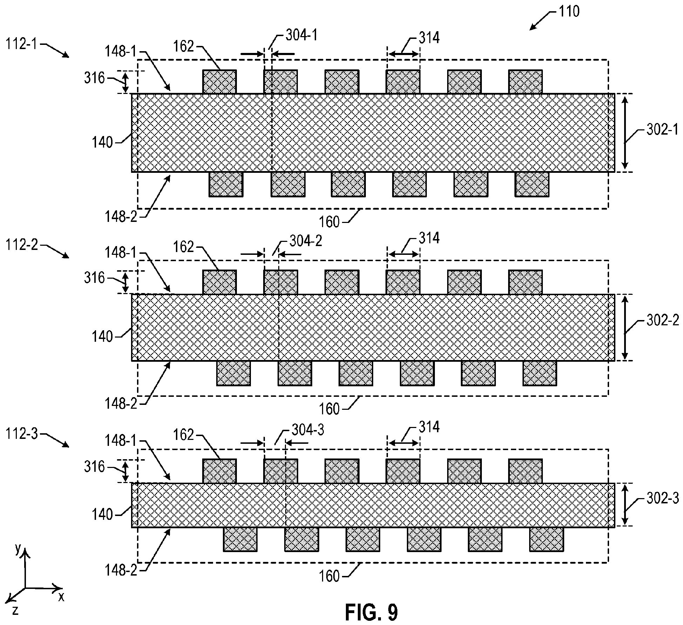

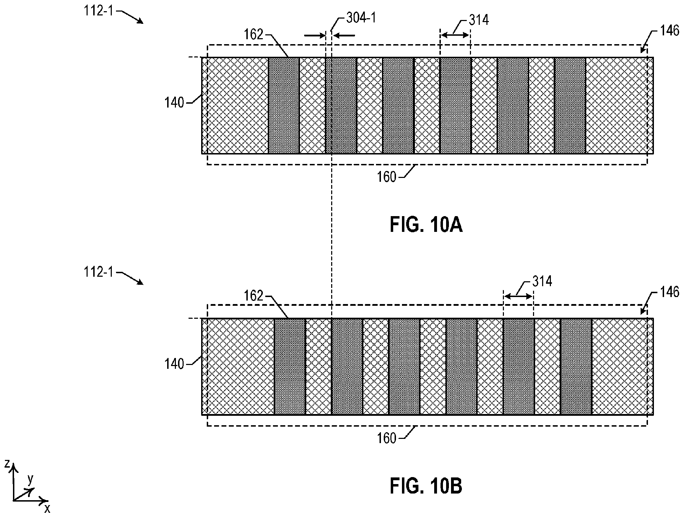

FIG. 8 illustrates top-down views of the waveguides 140 with sidewall gratings 160 (e.g., gratings on the sidewalls 148-1 and 148-2 of the waveguides 140) and different effective widths that may be used in different lasers 112 of an integrated laser array 110, and with perturbations 162 of the gratings 160 being implemented as trenches according to an embodiment. FIG. 9 illustrates top-down views of the waveguides 140 with sidewall gratings 160 and different effective widths as in FIG. 8, but with perturbations 162 of the gratings 160 being implemented as ridges according to an embodiment. FIGS. 10A and 10B illustrate cross-sectional side views of one of the waveguides 140 of FIGS. 8 and 9 in cross-sections of sidewall gratings on two different sidewalls 148, according to an embodiment.

As shown in FIG. 8, the waveguides 140 of different lasers 112 may include a core portion having a width 302, shown as a width 302-1 for the laser 112-1, a width 302-2 for the laser 112-2, and a width 302-3 for the laser 112-3. As also shown in FIG. 8, the waveguides 140 may also include sidewall portions with perturbations 162 of the gratings 160. In particular, FIG. 8 illustrates that the perturbations 162 may be trenches implemented in the sidewalls 148 of the waveguides 140, where the trenches extend from the surface 148 towards the core portions of the waveguides 140. The effective refractive index of the waveguides 140 of different lasers 112 may be changed by changing the widths 302 of the core portions of these lasers. As shown in FIG. 8, the width 302-2 is smaller than the width 302-1, and the width 302-3 is smaller than the width 302-2. The depth 312 and the width 314 of the trenches implementing the perturbations 162 in the example of FIG. 8 may remain substantially the same from one laser 112 to another. As a result, effective widths of different lasers 112 of a laser array 110 as shown in FIG. 8 are different. As used herein, the term "effective width" of the waveguide 140 refers to an area of the waveguide 140 in a plane parallel to the support (e.g., an area of a footprint of the top surface 146 of the waveguide 140) divided by a length of the waveguide 140 in that plane (e.g., a length of the footprint of the top face of the waveguide). Phrased differently, an "effective width" of the waveguide 140 may be defined as an average of widths of the waveguide 140 along a longitudinal axis of the waveguide 140. In some embodiments, an effective width of the waveguide 140 of one of the lasers 112 may be different from an effective width of the waveguide 140 of another one of the lasers 112 by between about 1% and about 10%, e.g., between about 1% and about 5%, of the effective width of one of these lasers. In some embodiments, the depth 312 of the trenches implementing the perturbations 162 in the example of FIG. 8 may be less than about 75% of the effective width of the waveguide 140, e.g., less than about 50% of the effective width of the waveguide 140, or less than about 25% of the effective width of the waveguide 140.

When the gratings 160 are implemented on one or more sidewalls 148 of a waveguide 140, a change in the effective width of the waveguide 140 changes the relative amounts (e.g., changes the weighted average) of the materials of the waveguide 140 (e.g., materials in the core portion and between the trenches or in the ridges of the perturbations 162 of the grating 160) and materials of the surrounding medium (e.g., materials filling the trenches or materials between the ridges of the perturbations 162 of the grating 160). Because materials of the waveguide 140 and materials of the surrounding medium have different refractive indices, a change in the effective width of the waveguide 140 results in the change in the effective refractive index of the waveguide 140, which, in turn, leads to the change in the wavelength supported by the waveguide 140.

In some implementations, a change in the effective width of a waveguide 140 from one laser 112 to another in a laser array 110 may lead to changes in the grating strengths of the gratings 160 of different lasers 112, which may be undesirable. The changes in the grating strengths may then be compensated by adjusting the offset of the perturbations 162 on the opposite sidewalls 148. As shown in FIG. 8, for the laser 112-1, the perturbations 162 on the sidewall 148-2 are offset from the perturbations 162 on the sidewall 148-1 by an offset 304-1. As further shown in FIG. 8, for the laser 112-2, the perturbations 162 on the sidewall 148-2 are offset from the perturbations 162 on the sidewall 148-1 by an offset 304-2. Finally, for the laser 112-3, the perturbations 162 on the sidewall 148-2 are offset from the perturbations 162 on the sidewall 148-1 by an offset 304-3. For example, in some embodiments, an offset 304 of the perturbations 162 on the opposite sidewalls 148 of the waveguide 140 of one of the lasers 112 may be different from an offset 304 of the perturbations 162 on the opposite sidewalls 148 of the waveguide 140 of another one of the lasers 112 by between about 1% and about 10%, e.g., between about 1% and about 5%, of the offset 304 of the perturbations 162 on the opposite sidewalls 148 of one of these lasers. As shown in FIG. 8, when the effective width decreases from the laser 112-1 to the laser 112-3, the offset 304 may increase. Thus, because the effective width of the waveguide 140 of the laser 112-2 of FIG. 8 is smaller than the effective width of the waveguide 140 of the laser 112-1, the offset 304-2 of the laser 112-2 is larger than the offset 304-1 of the laser 112-1. Similarly, because the effective width of the waveguide 140 of the laser 112-3 of FIG. 8 is smaller than the effective width of the waveguide 140 of the laser 112-2, the offset 304-3 of the laser 112-3 is larger than the offset 304-2 of the laser 112-2.

FIG. 9 illustrates a laser array 110 similar to that shown in FIG. 8, except where the perturbations 162 are implemented as ridges. Such ridges may extend away from the respective sidewalls 148 of the waveguide 140 to a certain height 316 (e.g., the dimension of the perturbations 162 in a direction perpendicular to the respective sidewalls 148). In some embodiments, the height 316 may be at least about 5% of the average widths 302 of the core portions of all of the waveguides 140 in the laser array 110, e.g., at least about 15%, or at least about 25%. In some embodiments, the height 316 may be less than about 75% of the effective width of the waveguide 140, e.g., less than about 50% of the effective width of the waveguide 140, or less than about 25% of the effective width of the waveguide 140.

FIGS. 10A and 10B illustrate cross-sectional side views of one of the waveguides 140 of FIGS. 8 and 9 in cross-sections of sidewall gratings on two different sidewalls 148, according to an embodiment. In particular, FIG. 10A illustrates a cross-sectional side view of the waveguide 140 of the laser 112-1 of FIGS. 8 and 9 in a cross-section across the perturbations 162 on the sidewall 148-1, while FIG. 10B illustrates a cross-sectional side view of the waveguide 140 of the laser 112-1 of FIGS. 8 and 9 in a cross-section across the perturbations 162 on the sidewall 148-2. The cross-sectional side views of FIGS. 10A and 10B illustrate that the perturbations 162 are elongated perturbations having their long axis, or extending in a direction, perpendicular to the longitudinal axis of the waveguide 140. In other words, the perturbations 162 of the laser array 110 described with reference to FIGS. 8-10 extend in a direction perpendicular to the direction of propagation of light emitted by the light-emitter structure 150.

Although the perturbations 162 on each of the sidewalls 148 are shown in FIGS. 8-10 are having the same period for all of the lasers 112, in some embodiments, embodiments explained with reference to FIGS. 8-10 may be combined with embodiments explained with reference to FIGS. 5-7, e.g., as is shown in FIGS. 4A-4B.

Arrangements with two or more lasers 112 of a laser array 110 according to any embodiments disclosed herein may be included in any suitable electronic device. FIGS. 11-13 illustrate various examples of devices and components that may include lasers 112 of a laser array 110 according to any embodiments disclosed herein, or any combination of such embodiments, or may include photonic devices 100 with one or more of such laser arrays 110.

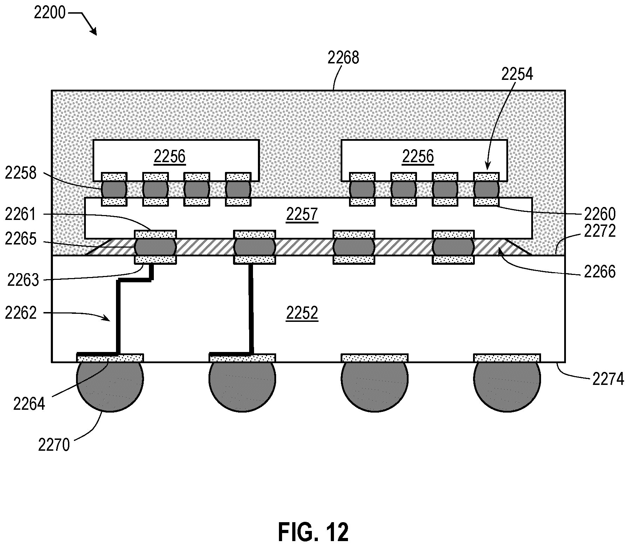

FIG. 11 illustrates top views of a wafer 2100 and dies 2102 that may be included in a photonic device with an integrated laser array, according to an embodiment, e.g., in a photonic device 100 that includes a laser array 110 and other components such as modulators and a multiplexer as described herein, or in a photonic device 100 that only includes a laser array 110 according to any of the embodiments described herein, or any combination of such embodiments. In some embodiments, the dies 2102 may be included in an IC package, in accordance with any of the embodiments disclosed herein. For example, any of the dies 2102 may serve as any of the dies 2256 in an IC package 2200 shown in FIG. 12. The wafer 2100 may be composed of semiconductor material and may include one or more dies 2102 having IC structures formed on a surface of the wafer 2100. Each of the dies 2102 may be a repeating unit of a semiconductor product that includes any suitable IC (e.g., ICs including one or more IC devices implementing laser arrays 110 and/or photonic devices 100 as described herein). After the fabrication of the semiconductor product is complete (e.g., after manufacture of any embodiment of the laser arrays 110 and/or photonic devices 100 as described herein), the wafer 2100 may undergo a singulation process in which each of the dies 2102 is separated from one another to provide discrete "chips" of the semiconductor product. In particular, devices that include one or more laser arrays 110 and/or photonic devices 100 as described herein may take the form of the wafer 2100 (e.g., not singulated) or the form of the die 2102 (e.g., singulated). The die 2102 may include supporting circuitry to route electrical and/or optical signals to various components, e.g., to various lasers 112, transistors, capacitors, resistors, as well as any other IC components. In some embodiments, the wafer 2100 or the die 2102 may implement or include a laser array (e.g., any embodiments of the laser array 110 with two or more lasers 112 as described herein), a photonic device with a laser array (e.g., any embodiments of the photonic device 100), or any other suitable circuit element. Multiple ones of these devices may be combined on a single die 2102. For example, a laser array 110 formed by multiple lasers 112 as described herein may be formed on a same die 2102.

FIG. 12 is a side, cross-sectional view of an example microelectronic package 2200 that may include one or more laser arrays and/or photonic devices in accordance with any of the embodiments disclosed herein. In some embodiments, the microelectronic package 2200 may be a system-in-package (SiP).

The package substrate 2252 may be formed of a dielectric material (e.g., a ceramic, a buildup film, an epoxy film having filler particles therein, etc.), and may have conductive pathways 2262 extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The microelectronic package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 12 are solder bumps, but any suitable first-level interconnects 2265 may be used. In some embodiments, no interposer 2257 may be included in the microelectronic package 2200; instead, the dies 2256 may be coupled directly to the conductive contacts 2263 at the face 2272 by first-level interconnects 2265.

The microelectronic package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 12 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 12 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the microelectronic package 2200 to another component, such as a circuit board (e.g., a motherboard), an interposer, or another IC package, as known in the art.

The dies 2256 may take the form of any of the embodiments of the die 2102 discussed herein (e.g., may include any of the embodiments of the IC devices with laser arrays 110 and/or photonic devices 100 as described herein). In embodiments in which the microelectronic package 2200 includes multiple dies 2256, the microelectronic package 2200 may be referred to as a multi-chip package (MCP). The dies 2256 may include circuitry to perform any desired functionality. In some embodiments, any of the dies 2256 may include one or more laser arrays 110 and/or photonic devices 100 as described herein; in some embodiments, at least some of the dies 2256 may not include any laser arrays 110 or photonic devices 100 as described herein.

The microelectronic package 2200 illustrated in FIG. 12 may be a flip chip package, although other package architectures may be used. For example, the microelectronic package 2200 may be a ball grid array (BGA) package, such as an embedded wafer-level ball grid array (eWLB) package. In another example, the microelectronic package 2200 may be a wafer-level chip scale package (WLCSP) or a panel fan-out (FO) package. Although two dies 2256 are illustrated in the microelectronic package 2200 of FIG. 12, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

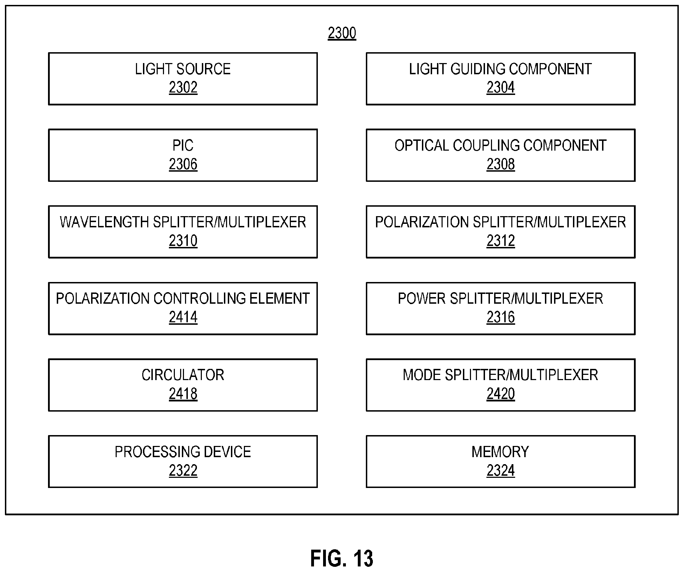

FIG. 13 is a block diagram of an example photonic device 2300 that may include one or more components in which laser arrays and/or photonic devices as described herein may be implemented. For example, any suitable ones of the components of the photonic device 2300 may include a die (e.g., the die 2102 of FIG. 11) having one or more microelectronic packages (e.g., microelectronic packages 2200 of FIG. 12). More generally, any suitable ones of the components of the photonic device 2300 may include one or more of laser arrays 110 and/or photonic devices 100 as described herein.

A number of components are illustrated in FIG. 13 as included in the photonic device 2300, but any one or more of these components may be omitted or duplicated, as suitable for the application. In some embodiments, some or all of the components included in the photonic device 2300 may be attached to one or more motherboards or any suitable support structure. In some embodiments, some or all of these components are fabricated onto a single system-on-chip (SoC) die. Additionally, in various embodiments, the photonic device 2300 may not include one or more of the components illustrated in FIG. 13, but the photonic device 2300 may include interface circuitry for coupling to the one or more components. For example, the photonic device 2300 may not include a processing device 2322, but may include processing device interface circuitry (e.g., a connector and driver circuitry) to which a processing device 2322 may be coupled. In another example, the photonic device 2300 may not include a memory 2324, but may include memory interface circuitry (e.g., connectors and supporting circuitry) to which a memory 2324 may be coupled. In yet another example, the photonic device 2300 may not include a circulator 2318, but may include circulator interface circuitry (e.g., connectors) to which a circulator 2318 may be coupled

In some embodiments, the photonic device 2300 may include at least one light source 2302. In some embodiments, the light source 2302 may be, or may include, a laser array 110 as described herein. In general, the light source 2302 may include any suitable device for providing the necessary optical signals for various applications of the photonic device 2300, ranging from communication to sensing and imaging. The light source 2302 may be designed to emit light in a controlled and efficient manner to meet the specific requirements of the photonic device 2300. In some embodiment, the light source 2302 may be a coherent and monochromatic light source such as a laser, to produce light of a well-defined wavelength, low divergence, and high brightness. Examples of lasers that may be included in the light source 2302 include semiconductor lasers, such as edge-emitting lasers and vertical-cavity surface-emitting lasers (VCSELs). Such lasers may be particularly advantageous when the photonic device 2300 is used in applications like optical communication, sensing, and laser-based treatments in medical devices. In some embodiment, the light source 2302 may be a non-coherent light source such as a light-emitting diode (LED) that emits light when an electric current is applied. LEDs may be simpler and more cost-effective than lasers, making them suitable for applications where high coherence is not required. Using an LED as the light source 2302 may be particularly advantageous when the photonic device 2300 is used in applications like displays, optical sensors, and short-distance communication systems. In further embodiments, the light source 2302 may include one or more of a superluminescent diode (SLD), a quantum dot, a rare-earth-doped fiber/waveguide, a plasma source (e.g., plasmonics and microplasma devices), a microcavity resonators, or a nonlinear optical device (e.g., a photonic device that uses nonlinear optical processes, such as frequency doubling or parametric amplification, to generate new wavelengths).

In some embodiments, the photonic device 2300 may include at least one light guiding component 2304, such as a waveguide, to manipulate and control the propagation of light. The light guiding component 2304 may include any suitable waveguide structures designed to confine and guide light along a specified path, allowing it to travel from one point to another with minimal loss and dispersion. Examples of waveguides that may be used as the light guiding component 2304 include planar waveguides, optical fibers, photonic crystal waveguides, and rib waveguides. In some embodiments, the light guiding component 2304 may include a material with a higher refractive index, known as the "core," surrounded by a material with a lower refractive index, known as the "cladding." The refractive index contrast between the core and cladding helps guide light within the core by using total internal reflection. Light is trapped within the core due to its reflection at the core-cladding interface. The light guiding component 2304 may support various modes of light propagation, such as single-mode or multimode.

In some embodiments, the photonic device 2300 may include at least one PIC 2306. A PIC 2306 may be a miniaturized and integrated optical device that incorporates photonic components, such as optical modulators, photodetectors, and waveguides, onto a single substrate. In some embodiments, the PIC 2306 may include one or more optical modulators for encoding data onto an optical signal, e.g., onto light generated by the light source 2302. An optical modulator of the PIC 2306 may change certain properties of an optical signal, such as its amplitude, frequency, or phase, in order to encode information onto the signal or to perform various signal processing functions. Examples of optical modulators that may be implemented in the PIC 2306 include electro-optic modulators, MZI modulators, or microring modulators. In some embodiments, the PIC 2306 may include one or more photodetectors for detecting and measuring the intensity of light or optical radiation across various wavelengths by converting incident light/photons into an electrical signal. Examples of photodetectors that may be implemented in the PIC 2306 include photodiodes, avalanche photodiodes, phototransistors, PIN diodes, CMOS image sensors, photomultiplier tubes, or quantum photodetectors. In some embodiments, the PIC 2306 may include one or more waveguides, e.g., any of the waveguides described with reference to the light guiding component 2304.

In some embodiments, the photonic device 2300 may include at least one optical coupling component 2308. The optical coupling component 2308 may include any suitable structures designed to facilitate efficient transfer of light between different optical devices, e.g., between the light source 2302 and the light guiding component 2304, between the light source 2302 and the PIC 2306, between the light guiding component 2304 and the PIC 2306, or between the light guiding component 2304 or the PIC 2306 and a further transmission line such as a fiber (not shown in FIG. 13) that may be coupled to the photonic device 2306. Examples of optical coupling elements that may be used to implement the optical coupling component 2308 include fiber couplers (e.g., fused fiber couplers or tapered fiber couplers), waveguide couplers, grating couplers, lens couplers, microlens couplers, prism couplers, fiber array couplers, or ball lens couplers.

In some embodiments, the photonic device 2300 may include at least one wavelength splitter/multiplexer 2310, to combine or split multiple optical signals that are carried at different wavelengths. This may be particular advantageous if the photonic device 2300 is used in an optical communication system such as a WDM system or a DWDM system, where multiple data channels are transmitted simultaneously over a single optical fiber using different wavelengths of light. In various embodiments, the wavelength splitter/multiplexer 2310 may include a wavelength division multiplexer, a wavelength division demultiplexer, a passive optical add/drop multiplexer, an arrayed waveguide grating, a fused fiber couplers, and interleavers, or an optical filter based device.

In some embodiments, the photonic device 2300 may include at least one polarization splitter/multiplexer 2312, to combine or split multiple optical signals depending on their polarization. Similarly, in some embodiments, the photonic device 2300 may include at least one polarization controlling component 2314, to control polarization of light generated and manipulated in the photonic device 2300. In various embodiments, a polarization splitter/multiplexer 2312 and a polarization controlling component 2314 may include any suitable structure to enable the manipulation and management of polarized light signals, such as birefringent materials, waveguide structures, or specialized coatings that interact differently with different polarization states.

In some embodiments, the photonic device 2300 may include at least one general power splitter/multiplexer 2316, to combine or split multiple optical signals that in a manner that is not dependent on wavelength or polarization. For example, in some embodiments a power splitter/multiplexer 2316 may be used to tap off a small amount of optical power for purposes or power monitoring in the photonic device 2300. Examples of devices that may be used as a power splitter/multiplexer 2316 include directional couplers and multimode interference couplers.

In some embodiments, the photonic device 2300 may include at least one circulator 2318, also referred to as a "directional splitter." The circulator 2318 may include any suitable device configured to direct light signals to travel in a specific, one-way circular path through its ports. In some embodiments, the circulator 2318 may include magneto-optic materials or other techniques that create a Faraday rotation effect, where the polarization of light is rotated as it passes through the circulator 2318.

In some embodiments, the photonic device 2300 may include at least one mode splitter/multiplexer 2320, to combine or split multiple optical signals based on their guided modes. Examples of devices that may be used as a mode splitter/multiplexer 2320 include directional couplers, multimode interference couplers, tapered waveguide couplers, photonic lanterns, or photonic crystal splitters.

In some embodiments, the photonic device 2300 may include a processing device 2322 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2322 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. In some embodiments, the processing device 2322 may include circuitry to control operation of other components of the photonic device 2300, e.g., to control operation of the PIC 2306.

In some embodiments, the photonic device 2300 may include a memory 2324, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2322. This memory may be used as cache memory and may include embedded DRAM (eDRAM) or spin transfer torque magnetic random-access memory (MRAM). In some embodiments, the memory 2324 may store instructions or data for the processing device 2322 to control operation of other components of the photonic device 2300, e.g., to control operation of the PIC 2306.

The following paragraphs provide examples of various ones of the embodiments disclosed herein.

Example 1 provides a photonic device that includes: a support (e.g., a die, a wafer, a substrate, or a chip); and one or more lasers provided over the support, an individual laser of the one or more lasers including a light-emitter structure in a first layer over the support, the light-emitter structure configured to emit light, and a waveguide in a second layer over the support. The waveguide is configured to guide the light emitted by the light-emitter structure and includes a top face, a bottom face opposite the top face, a first sidewall, and a second sidewall opposite the first sidewall. The waveguide also includes first elongated perturbations extending in a direction perpendicular to a longitudinal axis of the waveguide (in other words, first elongated perturbations extend in a direction perpendicular to the direction of propagation of light emitted by the light-emitter structure) from a first line on a face of the waveguide to a closest edge (e.g., a top) of the first sidewall and further extending from the closest edge of the first sidewall towards an opposite edge (e.g., a bottom) of the first sidewall, wherein the face is either the top face or the bottom face of the waveguide. The waveguide further includes second elongated perturbations extending in the direction perpendicular to the longitudinal axis of the waveguide (in other words, second elongated perturbations extend in a direction perpendicular to the direction of propagation of light emitted by the light-emitter structure) from a second line on the face of the waveguide to a closest edge (e.g., a top) of the second sidewall and further extending from the closest edge of the second sidewall towards an opposite edge (e.g., a bottom) of the second sidewall, wherein, in a direction parallel to the longitudinal axis of the waveguide, the second elongated perturbations are offset from the first elongated perturbations by a non-zero distance.

Example 2 provides the photonic device according to example 1, wherein the one or more lasers include a first laser and a second laser, the first elongated perturbations of the first laser have a first effective pitch, the first elongated perturbations of the second laser have a second effective pitch, and the second effective pitch is different from the first effective pitch.

Example 3 provides the photonic device according to example 2, wherein the second effective pitch is different from the first effective pitch by less than about 8 angstroms, e.g., by less than about 5 angstroms, or by about 1 angstrom.

Example 4 provides the photonic device according to examples 2 or 3, wherein each of the first effective pitch and the second effective pitch is greater than about 100 nanometers, e.g., greater than about 150 nanometers, or equal to or greater than about 200 nanometers.

Example 5 provides the photonic device according to any one of examples 2-4, wherein, for the first laser, a portion of the waveguide that includes the first elongated perturbations and the second elongated perturbations has a first effective width; for the second laser, a portion of the waveguide that includes the first elongated perturbations and the second elongated perturbations has a second effective width; and the second effective width is different from the first effective width. As used herein, the term "effective width" of a waveguide refers to an area of the waveguide in a plane parallel to the support (e.g., an area of a footprint of the top face of the waveguide) divided by a length of the waveguide in that plane (e.g., a length of the footprint of the top face of the waveguide).

Example 6 provides the photonic device according to example 5, wherein the second effective width is different from the first effective width by between about 1% and about 10%, e.g., between about 1% and about 5%, of the first effective width.

Example 7 provides the photonic device according to example 1, wherein the one or more lasers include a first laser and a second laser; for the first laser, a portion of the waveguide that includes the first elongated perturbations and the second elongated perturbations has a first effective width; for the second laser, a portion of the waveguide that includes the first elongated perturbations and the second elongated perturbations has a second effective width, and the second effective width is different from the first effective width.

Example 8 provides the photonic device according to example 7, wherein the second effective width is different from the first effective width by between about 1% and about 10%, e.g., between about 1% and about 5%, of the first effective width.

Example 9 provides the photonic device according to any one of the preceding examples, wherein the first elongated perturbations include a first plurality of the first elongated perturbations having a first pitch (a pitch defined as, e.g., a center-to-center distance), and a second plurality of the first elongated perturbations having a second pitch different from the first pitch, wherein each of the first pitch and the second pitch is greater than about 100 nanometers, e.g., greater than about 150 nanometers, or equal to or greater than about 200 nanometers.

Example 10 provides the photonic device according to example 9, wherein the one or more lasers include a first laser and a second laser, and a number of the first elongated perturbations in the second plurality of the first elongated perturbations of the second laser is different from a number of the first elongated perturbations in the second plurality of the first elongated perturbations of the first laser.

Example 11 provides the photonic device according to examples 9 or 10, wherein an effective pitch of the first elongated perturbations is an average of pitches of all elongated perturbations of the first elongated perturbations.

Example 12 provides the photonic device according to any one of the preceding examples, wherein the non-zero distance of an offset between the second elongated perturbations and the first elongated perturbations is less than an effective pitch of the first elongated perturbations and less than an effective pitch of the second elongated perturbations.

Example 13 provides the photonic device according to any one of the preceding examples, wherein the first and second lines are substantially parallel to the longitudinal axis of the waveguide and are at a non-zero distance from one another.

Example 14 provides the photonic device according to example 13, wherein the non-zero distance between the first and second lines is less than about 50% of an effective width of the waveguide.

Example 15 provides the photonic device according to any one of examples 1-14, wherein the first elongated perturbations and/or the second elongated perturbations are trenches.

Example 16 provides the photonic device according to any one of examples 1-14, wherein the first elongated perturbations and/or the second elongated perturbations are ridges.

Example 17 provides the photonic device according to any one of the preceding examples, wherein the light-emitter structure includes a III-V semiconductor material and/or wherein the waveguide includes silicon.

Example 18 provides the photonic device according to any one of examples 1-17, wherein the second layer is closer to the support than the first layer.

Example 19 provides the photonic device according to any one of examples 1-17, wherein the second layer is closer to the support than the first layer.

Example 20 provides the photonic device according to any one of examples 1-17, wherein, for the individual laser, a footprint of the light-emitter structure overlaps with a footprint of the first elongated perturbations and/or a footprint of the light-emitter structure further overlaps with a footprint of the second elongated perturbations, or a footprint of the light-emitter structure is adjacent to a footprint of the first elongated perturbations in the direction parallel to the longitudinal axis of the waveguide.

Example 21 provides a photonic device including a laser array that includes: a first laser and a second laser, wherein: each laser of the first laser and the second laser includes a light-emitter structure including a III-V semiconductor material, and further includes a waveguide with a grating, the grating including silicon; an effective pitch of the grating of the second laser is different from an effective pitch of the grating of the first laser by less than about 1 nanometer, e.g., less than about 5 angstroms; and a difference in center-to-center distances of any two pairs of adjacent (e.g., nearest-neighbor) elongated perturbations of the grating of the first laser and of the grating of the second laser is at least 1 nanometer.

Example 22 provides the photonic device according to example 21, wherein the effective pitch of the grating of the second laser is different from the effective pitch of the grating of the first laser by about 1 angstrom.

Example 23 provides the photonic device according to examples 21 or 22, wherein the grating includes a first plurality of elongated perturbations having a first pitch (a pitch defined as, e.g., a center-to-center distance), and a second plurality of elongated perturbations having a second pitch different from the first pitch, wherein each of the first pitch and the second pitch is greater than about 100 nanometers, e.g., greater than about 150 nanometers, or equal to or greater than about 200 nanometers.

Example 24 provides the photonic device according to example 23, wherein a number of elongated perturbations in the second plurality of elongated perturbations of the second laser is different from a number of elongated perturbations in the second plurality of elongated perturbations of the first laser.

Example 25 provides the photonic device according to examples 23 or 24, wherein an effective pitch of the grating is an average of pitches of all elongated perturbations of the grating.

Example 26 provides the photonic device according to any one of examples 21-25, wherein the waveguide is above with the light-emitter structure.

Example 27 provides the photonic device according to example 26, further including a support (e.g., a substrate, a die, or a wafer), wherein the light-emitter structure is between the support and the waveguide.

Example 28 provides the photonic device according to any one of examples 21-52, wherein the waveguide is below the light-emitter structure.

Example 29 provides the photonic device according to example 28, further including a support (e.g., a substrate, a die, or a wafer), wherein the waveguide is between the support and the light-emitter structure.

Example 30 provides the photonic device according to examples 27 or 29, wherein the support is a substrate including silicon.

Example 31 provides the photonic device according to any one of examples 26-30, wherein a footprint of the grating overlaps with a footprint of the light-emitter structure.

Example 32 provides the photonic device according to any one of examples 21-25, wherein the grating is adjacent to the light-emitter structure along a longitudinal axis of the light-emitter structure.

Example 33 provides the photonic device according to any one of examples 21-32, wherein a longitudinal axis of the grating is parallel to a longitudinal axis of the light-emitter structure.

Example 34 provides the photonic device according to any one of examples 21-33, wherein an effective width of the waveguide of the second laser is different from an effective width of the waveguide of the first laser.

Example 35 provides the photonic device according to example 34, wherein the effective width of the waveguide of the second laser is different from the effective width of the waveguide of the first laser by between about 1% and about 10%, e.g., between about 1% and about 5%, of the effective width of the waveguide of the first laser.

Example 36 provides the photonic device according to any examples 34 or 35, wherein the waveguide includes a first sidewall, a second sidewall opposite the first sidewall surface, a plurality of elongated perturbations at the first sidewall, and a plurality of elongated perturbations at the second sidewall, wherein the plurality of elongated perturbations at the second sidewall is offset from the plurality of elongated perturbations at the first sidewall.

Example 37 provides the photonic device according to example 36, wherein an offset between the plurality of elongated perturbations at the first sidewall and the plurality of elongated perturbations at the second sidewall of the waveguide of the second laser is different from an offset between the plurality of elongated perturbations at the first sidewall and the plurality of elongated perturbations at the second sidewall of the waveguide of the first laser.

Example 38 provides the photonic device according to example 37, wherein the offset between the plurality of elongated perturbations at the first sidewall and the plurality of elongated perturbations at the second sidewall of the waveguide of the second laser is different from the offset between the plurality of elongated perturbations at the first sidewall and the plurality of elongated perturbations at the second sidewall of the waveguide of the first laser by between about 1% and about 10%, e.g., between about 1% and about 5%, of the offset between the plurality of elongated perturbations at the first sidewall and the plurality of elongated perturbations at the second sidewall of the waveguide of the first laser.

Example 39 provides the photonic device according to any one of examples 36-38, wherein a height of the plurality of elongated perturbations at the first sidewall or a height of the plurality of elongated perturbations at the second sidewall is less than about 75% of an effective width of the waveguide. In this context, the height of the elongated perturbations refers to the dimension of the elongated perturbations in a direction perpendicular to the respective sidewall.

Example 40 provides the photonic device according to any one of examples 34-39, wherein an effective width of the waveguide is an average of widths of the waveguide along a longitudinal axis of the waveguide.

Example 41 provides the photonic device according to any one of examples 21-40, wherein the grating includes elongated trenches in one or more surfaces of the waveguide, the elongated trenches extending in a direction perpendicular to a longitudinal axis of the waveguide (in other words, the trenches extend in a direction perpendicular to the direction of propagation of light emitted by the light-emitter structure).

Example 42 provides the photonic device according to any one of examples 21-40, wherein the grating includes elongated ridges in one or more surfaces of the waveguide, the elongated ridges extending in a direction perpendicular to a longitudinal axis of the waveguide (in other words, the ridges extend in a direction perpendicular to the direction of propagation of light emitted by the light-emitter structure).

Example 43 provides a photonic device including a laser array that includes a first laser and a second laser, wherein each laser of the first laser and the second laser includes a light-emitter structure including a III-V semiconductor material, and further includes a waveguide with sidewall gratings, the waveguide and gratings including silicon, and wherein an effective width of the waveguide of the second laser is different from an effective width of the waveguide of the first laser.

Example 44 provides the photonic device according to example 43, wherein the effective width of the waveguide of the second laser is different from the effective width of the waveguide of the first laser by between about 1% and about 10%, e.g., between about 1% and about 5%, of the effective width of the waveguide of the first laser.

Example 45 provides the photonic device according to any examples 43 or 44, wherein the waveguide includes a first sidewall, a second sidewall opposite the first sidewall, a plurality of elongated perturbations at the first sidewall, and a plurality of elongated perturbations at the second sidewall, wherein the plurality of elongated perturbations at the second sidewall is offset from the plurality of elongated perturbations at the first sidewall.

Example 46 provides the photonic device according to example 45, wherein an offset between the plurality of elongated perturbations at the first sidewall and the plurality of elongated perturbations at the second sidewall of the waveguide of the second laser is different from an offset between the plurality of elongated perturbations at the first sidewall and the plurality of elongated perturbations at the second sidewall of the waveguide of the first laser.

Example 47 provides the photonic device according to example 46, wherein the offset between the plurality of elongated perturbations at the first sidewall and the plurality of elongated perturbations at the second sidewall of the waveguide of the second laser is different from the offset between the plurality of elongated perturbations at the first sidewall and the plurality of elongated perturbations at the second sidewall of the waveguide of the first laser by between about 1% and about 10%, e.g., between about 1% and about 5%, of the offset between the plurality of elongated perturbations at the first sidewall and the plurality of elongated perturbations at the second sidewall of the waveguide of the first laser.

Example 48 provides the photonic device according to any one of examples 45-47, wherein a height of the plurality of elongated perturbations at the first sidewall or a height of the plurality of elongated perturbations at the second sidewall is less than about 75% of an effective width of the waveguide. In this context, the height of the elongated perturbations refers to the dimension of the elongated perturbations in a direction perpendicular to the respective sidewall.

Example 49 provides the photonic device according to any one of examples 45-48, wherein the elongated perturbations at the first sidewall are elongated trenches extending in a direction perpendicular to a longitudinal axis of the waveguide (in other words, the trenches extend in a direction perpendicular to the direction of propagation of light emitted by the light-emitter structure).

Example 50 provides the photonic device according to any one of examples 45-48, wherein the elongated perturbations at the first sidewall are elongated ridges extending in a direction perpendicular to a longitudinal axis of the waveguide (in other words, the ridges extend in a direction perpendicular to the direction of propagation of light emitted by the light-emitter structure).

Example 51 provides the photonic device according to any one of the preceding examples, wherein the photonic device includes a laser array including N lasers, N is an integer greater than 1, the one or more lasers of any one of examples 1-20, or the first and second lasers of any one of examples 21-50 are lasers of the N lasers, and different lasers of the N lasers are configured to output light of different central wavelengths.

Example 52 provides the photonic device according to example 51, wherein a wavelength spacing of the different lasers of the laser array is equivalent to about 100 GHz of a frequency spacing.

Example 53 provides the photonic device according to examples 51 or 52, wherein the light-emitter structures of the different lasers are configured to emit light of about the same wavelengths.

Example 54 provides the photonic device according to any one of examples 51-53, further including a wavelength combiner configured to combine the light output by the N lasers into a single optical signal.

Example 55 provides the photonic device according to example 54, further including a splitter configured to split the single optical signal into M optical signals, wherein M is an integer greater than 1, and wherein M may be, but does not have to be, equal to N.

Example 56 provides the photonic device according to example 55, wherein each of the M optical signals is a signal including the different central wavelengths of the N lasers.

Example 57 provides the photonic device according to example 56, further including a respective plurality of modulators in a path of the each of the M optical signals.

Example 58 provides the photonic device according to example 57, wherein the modulators are ring modulators.

Example 59 provides the photonic device according to examples 57 or 58, wherein the modulators are silicon modulators.

Example 60 provides the photonic device according to any one of examples 55-59, further including an NxM multiplexer, wherein the NxM multiplexer includes the wavelength combiner and the splitter.

Example 61 provides the photonic device according to any one of examples 51-60, further including a respective backside termination for each of the N lasers.

Example 62 provides the photonic device according to any one of examples 51-61, wherein the light output by each of the N lasers is an optical signal including a single central wavelength.

Example 63 provides the photonic device according to any one of the preceding examples, further including at least one of a circulator, a photodetector, a wavelength splitter, a polarization splitter, or a mode splitter.

Example 64 provides a microelectronic assembly that includes a die; and a further component coupled to the die, wherein the die includes a photonic device according to any one of the preceding examples.

Example 65 provides the microelectronic assembly according to example 64, wherein the further component is one of a package substrate, a circuit board, an interposer, or another die.

Example 66 provides the microelectronic assembly according to examples 64 or 65, further including one or more interconnects to couple the further component to the die.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1.   A photonic device, comprising:

> a support; and
> one or more lasers over the support, an individual laser of the one or more lasers comprising a light-emitter structure in a first layer over the support, and a waveguide in a second layer over the support, the waveguide comprising:
>
>> a top face, a bottom face opposite the top face, a first sidewall, and a second sidewall opposite the first sidewall,
>> first elongated perturbations extending in a direction perpendicular to a longitudinal axis of the waveguide from a first line on a face of the waveguide to a closest edge of the first sidewall and further extending from the closest edge of the first sidewall towards an opposite edge of the first sidewall, wherein the face is either the top face or the bottom face of the waveguide, and second elongated perturbations extending in the direction perpendicular to the longitudinal axis of the waveguide from a second line on the face of the waveguide to a closest edge of the second sidewall and further extending from the closest edge of the second sidewall towards an opposite edge of the second sidewall,
>> wherein, in a direction parallel to the longitudinal axis of the waveguide, the second elongated perturbations are offset from the first elongated perturbations by a non-zero distance.

2.   The photonic device according to claim 1, wherein:

> the one or more lasers include a first laser and a second laser,
> the first elongated perturbations of the first laser have a first effective pitch,
> the first elongated perturbations of the second laser have a second effective pitch, and
> the second effective pitch is different from the first effective pitch.

3.   The photonic device according to claim 2, wherein the second effective pitch is different from the first effective pitch by less than about 5 angstroms.

4.   The photonic device according to claims 2 or 3, wherein each of the first effective pitch and the second effective pitch is greater than about 100 nanometers.

5.   The photonic device according to any one of claims 2-4, wherein:

> for the first laser, a portion of the waveguide that includes the first elongated perturbations and the second elongated perturbations has a first effective width,
> for the second laser, a portion of the waveguide that includes the first elongated perturbations and the second elongated perturbations has a second effective width, and
> the second effective width is different from the first effective width.

6.   The photonic device according to claim 5, wherein the second effective width is different from the first effective width by between about 1% and about 10% of the first effective width.

7.   The photonic device according to claim 1, wherein:

> the one or more lasers include a first laser and a second laser,
> for the first laser, a portion of the waveguide that includes the first elongated perturbations and the second elongated perturbations has a first effective width,
> for the second laser, a portion of the waveguide that includes the first elongated perturbations and the second elongated perturbations has a second effective width, and
> the second effective width is different from the first effective width.

8.   The photonic device according to any one of the preceding claims, wherein the first elongated perturbations include:

> a first plurality of the first elongated perturbations having a first pitch, and
> a second plurality of the first elongated perturbations having a second pitch different from the first pitch,
> wherein each of the first pitch and the second pitch is greater than about 100 nanometers.

9.   The photonic device according to any one of the preceding claims, wherein the non-zero distance of an offset between the second elongated perturbations and the first elongated perturbations is less than an effective pitch of the first elongated perturbations.

10. The photonic device according to any one of the preceding claims, wherein the first and second lines are substantially parallel to the longitudinal axis of the waveguide and are at a non-zero distance from one another.

11. A photonic device, comprising:

a first laser; and
a second laser,
wherein an individual laser of the first laser and the second laser includes a waveguide with a grating, an effective pitch of the grating of the second laser is different from an effective pitch of the grating of the first laser by less than about 5 angstroms, and a difference in center-to-center distances of any two pairs of adjacent elongated perturbations of the grating of the first laser and of the grating of the second laser is at least 1 nanometer.

12. The photonic device according to claim 11, wherein the grating includes:

a first plurality of elongated perturbations having a first pitch, and
a second plurality of elongated perturbations having a second pitch different from the first pitch,
wherein each of the first pitch and the second pitch is greater than about 100 nanometers.

13. A photonic device, comprising:

a first laser; and
a second laser,
wherein an individual laser of the first laser and the second laser includes a waveguide comprising a first sidewall, a second sidewall opposite the first sidewall, a plurality of elongated perturbations at the first sidewall, and a plurality of elongated perturbations at the second sidewall, wherein the plurality of elongated perturbations at the second sidewall is offset from the plurality of elongated perturbations at the first sidewall, and
wherein an offset between the plurality of elongated perturbations at the first sidewall and the plurality of elongated perturbations at the second sidewall of the waveguide of the second laser is different from an offset between the plurality of elongated perturbations at the first sidewall and the plurality of elongated perturbations at the second sidewall of the waveguide of the first laser.

14. The photonic device according to claim 13, wherein an effective width of the waveguide of the second laser is different from an effective width of the waveguide of the first laser by between about 1% and about 10% of the effective width of the waveguide of the first laser.

15. The photonic device according to claims 13 or 14, further comprising:

a wavelength combiner configured to combine light output by the first and second lasers into a single optical signal;
a splitter configured to split the single optical signal into M optical signals, wherein M is an integer greater than 1, and wherein each of the M optical signals is a signal comprising different wavelengths of the first and second lasers; and
a series of ring modulators in a path of the each of the M optical signals.

FIG. 1

FIG. 2A

FIG. 2B

300A

162 146

148-1

162

144

142

160-1 140

150

148-2 160-2

111

**FIG. 3A**

300B

146

162 162

148-1

144

142 140

160-1 160-2

148-2

111

**FIG. 3B**

**FIG. 4A**

**FIG. 4B**

FIG. 5

**FIG. 6**

FIG. 7

FIG. 8

FIG. 9

**FIG. 10A**

**FIG. 10B**

**FIG. 11**

2200

2268

2254

2256          2256

2258

2261
2265

2257

2260
2272

2263

2262          2252

2266

2264

2274

2270

**FIG. 12**

2300

| LIGHT SOURCE<br>2302 | LIGHT GUIDING COMPONENT<br>2304 |
| --- | --- |
| PIC<br>2306 | OPTICAL COUPLING COMPONENT<br>2308 |
| WAVELENGTH SPLITTER/MULTIPLEXER<br>2310 | POLARIZATION SPLITTER/MULTIPLEXER<br>2312 |
| POLARIZATION CONTROLLING ELEMENT<br>2414 | POWER SPLITTER/MULTIPLEXER<br>2316 |
| CIRCULATOR<br>2418 | MODE SPLITTER/MULTIPLEXER<br>2420 |
| PROCESSING DEVICE<br>2322 | MEMORY<br>2324 |

# FIG. 13